(19) Europäisches Patentamt
European Patent Office
Office européen des brevets

(11) **EP 4 411 842 A1**

(12) **EUROPEAN PATENT APPLICATION**

(43) Date of publication:
**07.08.2024   Bulletin 2024/32**

(21) Application number: **24155881.6**

(22) Date of filing: **05.02.2024**

(51) International Patent Classification (IPC):
**H01L 33/06** (2010.01)    **H01L 33/50** (2010.01)
**H01L 33/60** (2010.01)

(52) Cooperative Patent Classification (CPC):
**H01L 33/06; H01L 33/507; H01L 33/60**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.02.2023   US 202318106442**

(71) Applicant: **Bridgelux, Inc.**
**Fremont, CA 94538 (US)**

(72) Inventors:
• **LI, Yi-Qun**
  **Danville, 94526 (US)**
• **YUAN, Xianglong**
  **Manteca, 95337 (US)**
• **ZHAO, Jun-Gang**
  **Fremont, 94538 (US)**

(74) Representative: **Birdi, Sandeep Singh**
**24 Ibbetson Oval**
**Churwell**
**Morley, Leeds LS27 7RY (GB)**

(54) **FULL SPECTRUM WHITE LIGHT EMITTING DEVICES**

(57)    There is provided a white light emitting device comprising: a chip scale packaged broadband LED flip chip for generating broadband light of dominant wavelength from about 420 nm to about 480 nm and a FWHM from 25 nm to 50 nm; and at least one photoluminescence layer covering a light emitting face of the broadband LED flip chip; wherein the broadband LED flip chip comprises a broadband InGaN/GaN LED chip having an active region for directly generating blue light emissions of at least three different wavelengths using different quantum wells in a multiple-quantum well (MQW) structure, and wherein the at least one photoluminescence material layer comprises a first photoluminescence material for generating light with a peak emission wavelength from 490 nm to 550 nm; and a second photoluminescence material for generating light with a peak emission wavelength from 600 nm to 680 nm.

FIG. 10a

EP 4 411 842 A1

**Description**

CROSS REFERENCE TO RELATED APPLICATIONS

This application claims the benefit of priority to U.S. Patent Application No. 18/106,442 filed February 6, 2023, which is hereby incorporated by reference in its entirety.

FIELD OF THE INVENTION

Embodiments of the present invention are directed to full spectrum white light emitting devices comprising photoluminescence wavelength conversion materials. More particularly, although not exclusively, embodiments concern full spectrum white light emitting devices for generating full spectrum white light having a spectrum from blue light to red light that closely resembles sunlight. Furthermore, embodiments relate to Chip Scale Packaged (CSP) light emitting devices, such as a camera flash, for generating full spectrum white light.

BACKGROUND OF THE INVENTION

White light emitting LEDs ("white LEDs") include one or more photoluminescence materials (typically inorganic phosphor materials), which absorb a portion of the blue light emitted by the LED and re-emit visible light of a different color (wavelength). The portion of the blue light generated by the LED that is not absorbed by the phosphor material combined with the light emitted by the phosphor provides light which appears to the eye as being white in color. Due to their long operating life expectancy (>50,000 hours) and high efficacy (100 lumens per watt and higher), white LEDs are rapidly replacing conventional fluorescent, compact fluorescent and incandescent lamps.

Various metrics exist for quantifying the characteristics and quality of light generated by white lighting sources. The two most commonly used metrics within the solid-state lighting industry are, Correlated Color Temperature (CCT) and International Commission on Illumination (CIE) General Color Rendering Index (CRI) Ra.

The CCT of a lighting source is measured in kelvin (K) and is the color temperature of a Planckian (black-body) radiator that radiates light of a color that corresponds to the color of the light generated by the lighting source.

The General CRI Ra characterizes how faithfully a lighting source renders the true colors of an object and is based on a measure of how well a light source's illumination of eight color test samples (R1 to R8) compares with the illumination provided by a reference source. In general, the higher the value indicates its closeness to a black radiator and natural sunlight. General CRI Ra can take negative values and has a maximum value of 100. Since the color samples R1 to R8 are all pastel colors (low saturation colors "Light Grayish Red" to "Reddish Purple") the General CRI Ra gives a useful measure of subtle differences in light output of incandescent sources which generate a full spectrum that closely resembles sunlight. However, for white LEDs whose spectrum is composed of peaks, the General CRI Ra can prove to be inadequate as it is an average measure of color rendition over a limited range of colors and gives no information of the lighting source's performance for particular colors or highly saturated colors. Thus, when characterizing full spectrum solid-state white light emitting devices, the CRI color samples R9 to R12 (saturated colors "Saturated Red", "Saturated Yellow", "Saturated Green", "Saturated Blue") and R13 to R15 ("Light Skin Tone", "Leaf Green", "Medium Skin Tone") should be considered to give a meaningful characterization of full spectrum light.

There is growing concern that artificial light disrupts the normal regulation of human physiology and psychology, such as hormone synthesis, sleep-wake cycle, and level of alertness. In particular, recent evidence indicates that high color temperature (5000K) and high Illuminance light, such as, for example, light generated by LEDs, suppress pre-sleep melatonin secretion as well as reduce subjective alertness. It has also been reported that blue light has a greater tendency than other colors to affect living organisms through the disruption of their biological processes which rely upon natural cycles (circadian) of daylight and darkness. It is believed that exposure to blue light late in the evening and at night can be detrimental to health.

Various metrics have been proposed for predicting the melatonin suppression effect. Two of the more common metrics for measuring circadian stimulus are (i) Circadian Action Factor (CAF) and (ii) Melanopic Response (MR). CAF and MR are the ratio of the circadian luminous efficacy of radiation (CER) to luminous efficacy of radiation (LER) and each provide a measure of the brain's sensitivity to light, that is, a measure of human non-visual sensitivity to light. CAF is based on studies that measure human melatonin levels before and after exposure to specific wavelengths of light to establish a Circadian Action Spectrum (CAS). CAF, denoted $a_{cv}$, is the ratio of the circadian efficacy to luminous efficacy of radiation. MR is based on the absorption spectrum of the melanopsin photopigment found in mammalian ipRGCs (intrinsically photosensitive Retinal Ganglion Cells) to establish a melanopic response spectrum. MR is the ratio of the circadian efficacy to luminous efficacy of radiation. Recently, a new metric Equivalent Melanopic Lux (EML) has been proposed that is weighted to the spectral response of the ipRGCs.

Currently in the LED lighting industry, full spectrum LED devices seek to generate white light with a General CRI Ra equal to 100 such as is exhibited by incandescent lamps and black body radiation. Such LEDs, however, are found to sacrifice efficacy by 15 to 30% compared with white LEDs that generates light with a CRI Ra of about 80 (CRI80).

The present invention arose in an endeavor to overcome at least in part the shortcomings of known full spectrum LEDs and provide a full spectrum light emitting device, such as a camera flash, with an efficacy at least approaching that of current CRI80 devices.

A majority of smart phones come equipped with a digital camera and additionally include a flash unit to enable picture taking in low light conditions. The flash unit typically comprises a white LED in which the phosphor material is mixed with a liquid light transmissive material, such as silicone or epoxy material, and the mixture applied to at least one light emitting surface of the LED chip. It is the phosphor material that gives rise to the characteristic yellow to orange appearance of the flash unit in an off-state. While LED-based flash units are compact, it is desirable if they were capable of generating light with greater color rendering properties. Embodiments of the invention, at least in part, address this problem.

SUMMARY OF THE INVENTION

The invention concerns light emitting devices for generating full spectrum white light (full spectrum white light emitting devices) having a spectral content from blue light to red light that resembles natural sunlight as closely as possible. In particular, although not exclusively, embodiments of the invention are directed to ensuring that the full spectrum light resembles natural light in the blue to cyan region as closely as possible and optimizing (reducing) the deep red (e.g., corresponding to "Saturated Red" - CRI R9) of the spectrum to improve efficacy.

According to embodiments of the invention, full spectrum white light emitting devices generate full spectrum white light that closely resembles natural light in the blue to cyan (430 nm to 520 nm) region where human non-visual perception measured by Circadian Action Factor (CAF) is affected most. Full spectrum white light having such a spectral characteristic is believed to be beneficial to human wellbeing since this part of the spectral region impacts melatonin secretion which can influence the circadian cycle.

Full spectrum white light emitting devices in accordance with the invention utilize broadband solid-state excitation sources, for example blue LEDs, which generate broadband excitation light with a dominant wavelength in a range from about 420 nm to about 480 nm (that is in the blue region of the visible spectrum). In this patent specification, "broadband" light is used to denote light that has a FWHM (Full Width Half Maximum) of at least 25 nm, preferably at least 30 nm; or may be used to denote blue light that is composed of a combination of at least two different wavelength blue light emissions in a wavelength range from about 420 nm to about 480 nm. Use of broadband blue excitation light enables the light emitting device to generate full spectrum light that closely resembles natural light in blue to cyan (420 nm to 520 nm) region of the spectrum.

In embodiments, the broadband solid state excitation source comprises a broadband LED having an active region with at least two or at least three different quantum wells that each generate different blue light emissions.

The broadband solid-state excitation source may comprise, for example, a broadband blue LED such as an InGaN/GaN blue LED having an active region that directly generates blue light emissions of multiple different wavelengths using different quantum wells in a multiple-quantum-well (MQW) structure. Broadband solid-state excitation sources of the invention are to be contrasted with known light emitting devices that utilize narrowband blue LEDs that generate blue light of a single narrowband wavelength having a FWHM in a range 15 nm to 20 nm. Broadband blue solid-state excitation sources of the invention are to be further contrasted with known white LEDs that utilize UV solid-state light sources (UV LEDs) in which the blue excitation light is generated indirectly through a process of photoluminescence conversion of UV light using a blue light emitting (420 nm to 480 nm) photoluminescence material (phosphor). In other words, broadband solid-state excitation sources/white light emitting devices in accordance with the invention do not utilize/include a photoluminescence material to generate excitation light in a range 420 nm to 480 nm.

Embodiments of the invention find particular utility in CSP (Chip Scale Package) arrangements. In this specification, a CSP refers to a packaging arrangement that is on a chip scale and does not include a lead frame. A particular advantage of a CSP arrangement is the small size of the packaged device, which is comparable to the chip (die) size. As described herein, a CSP LED is an LED chip (die), typically an LED flip chip, having one or more photoluminescence material layers that cover one or more of its light emitting faces (e.g., top and/or side light emitting faces). As is known, an LED flip chip die has electrodes on its bottom face and a top light emitting face that is free of electrodes, bond wires or other packaging materials. The photoluminescence material layer(s) may be of a substantially uniform thickness and may be applied to the face(s) of the LED chip using, for example, an optical coupling layer. In the case where the photoluminescence material layer is deposited on only a top light emitting face of the flip chip, the photoluminescence material is prevented from contacting metal electrodes and packaging materials which might otherwise react with the photoluminescence material(s).

According to an aspect, the present invention encompasses a CSP white light emitting device comprising: a broadband LED flip chip for generating broadband light of dominant wavelength from about 420 nm to about 480 nm and a FWHM from 25 nm to 50 nm; and at least one photoluminescence layer covering a light emitting face of the broadband LED flip chip; wherein the broadband LED flip chip comprises a broadband InGaN/GaN multiple quantum wells LED chip comprising multiple different wavelength quantum wells in its active region that generate multiple narrowband light emissions of multiple different wavelengths and wherein broadband light generated by the broadband LED flip chip is composed of a combination of the multiple narrowband light emissions, and wherein the at least one photoluminescence material layer comprises a first photoluminescence material which generates light with a peak emission wavelength from 490 nm to 550 nm; and a second photoluminescence material which generates light with a peak emission wavelength from 600 nm to 680 nm.

According to an aspect, the present invention contemplates a white light emitting device comprising: a chip scale packaged (CSP) broadband LED flip chip for generating broadband light of dominant wavelength from about 420 nm to about 480 nm and a FWHM from 25 nm to 50 nm; and at least one photoluminescence layer covering a light emitting face of the broadband LED flip chip;_wherein the broadband LED flip chip comprises a broadband InGaN/GaN LED chip having an active region for directly generating blue light emissions of at least three different wavelengths using different quantum wells in a multiple-quantum well (MQW) structure, and wherein the at least one photoluminescence material layer comprises a first photoluminescence material for generating light with a peak emission wavelength from 490 nm to 550 nm; and a second photoluminescence material for generating light with a peak emission wavelength from 600 nm to 680 nm.

The device may comprise a camera flash. Preferably, the device is for generating white light (full spectrum) with a color temperature from 5000K to 6500K.

It may be that the broadband LED flip chip has a bottom face comprising anode and cathode contact pads and a light emitting top face, and wherein the at least one photoluminescence layer covers at least the light emitting top face.

The device may comprise a light transmissive material layer between the at least one photoluminescence layer and the light emitting top face of the LED flip chip. This may enhance the interface between the at least one photoluminescence layer and the light emitting top face of the LED flip chip causing improved light extraction from the LED flip chip and into the at least one photoluminescence layer.

It may be that the at least one photoluminescence layer is in direct contact with the light emitting top face of the LED flip chip. This may improve the robustness of the device since the at least one photoluminescence layer being in direct contact with the light emitting top face of the LED flip chip reduces likelihood of detachment of these features from one another, thereby reducing the risk of failure of the device.

The LED flip chip may comprise one or more light emitting side faces.

The at least one photoluminescence layer may cover the light emitting side faces of the LED flip chip.

The device may comprise a light reflective material covering the light emitting side faces of the LED flip chip. Such an arrangement increases the intensity of light generated by the device by preventing emission of light from the side faces of the LED chip and reflecting light back into the LED flip chip for subsequent emission from the front face of the LED flip chip. The device may comprise a light transmissive material disposed between the light reflective material and the light emitting side faces of the LED flip chip. The light transmissive material may be enclosed by the light reflective material and the at least one photoluminescence layer. Such an arrangement further increases the intensity of light generated by the device by ensuring that all emission of light from the LED flip chip passes through the at least one photoluminescence layer.

Alternatively, when the LED flip chip comprises one or more light emitting side faces the at least one photoluminescence layer can cover the light emitting side faces of the LED flip chip.

It may that the at least one photoluminescence layer is bonded to the LED flip chip by a light transmissive material. The at least one photoluminescence layer may be fabricated directly onto the LED flip chip.

The light transmissive material may reduce in thickness in a direction from the top face of the LED flip chip to the bottom face of the LED flip chip. The reduction in thickness in a direction from the top face of the LED flip chip to the bottom face of the LED flip chip may create an angle of reflection for light being emitted from the LED flip chip such that it is redirected towards the at least one photoluminescence layer thereby increasing the intensity of light generated by the device.

The light transmissive material may be arcuate in form.

The light transmissive material may reduce in thickness substantially linearly.

The light reflective material may be in direct contact with the light transmissive material.

The light transmissive material may further comprise a layer between the at least one photoluminescence layer and the light emitting top face of the LED flip chip.

The light transmissive material may be in direct contact with at least one of: the light reflective material; the light emitting top face of the LED flip chip; the light emitting side faces of the LED flip chip; or the at least one photoluminescence layer.

The device may comprise a light transmissive substrate/layer. The device may comprise a photoluminescence wavelength conversion component comprising the light transmissive substrate/layer and the at least one photoluminescence layer. The light transmissive substrate/layer may be a light transmissive glass substrate or a light transmissive polymer film layer. The photoluminescence wavelength conversion component can be configured with the at least one photoluminescence layer adjacent to the light emitting top face of the LED flip chip. Such an arrangement provides a benefit of the light transmissive substrate providing environmental protection to the photoluminescence materials, such as those within the at least one photoluminescence layer. Since the at least one photoluminescence layer may be thin, a few tens to a few hundred of micrometers in thickness, the light transmissive substrate can ease manufacture of the wavelength conversion component (and consequently the device) by depositing/fabricating the at least one photoluminescence layer directly on the light transmissive substrate.

An intensity of the white light generated by the device may decrease from its maximum value in the orange to red region of the spectrum to about 50% of said maximum value at a wavelength from about 645 nm to about 695 nm. This can increase luminous efficacy of the device.

In embodiments, the device generates full spectrum white light having a Correlated Color Temperature and an intensity versus wavelength spectrum, which over a wavelength range 460 nm to 600 nm, a maximum percentage deviation between the normalized intensity of the full spectrum white light emitted by the device compared with the normalized intensity of light of a black-body spectrum or CIE Standard Illuminant D of the same Correlated Color Temperature is less than ±30%. The maximum percentage deviation may be less than ±20%, and may be less than ±10%.

According to a further aspect, there is envisaged a camera flash comprising a broadband solid-state light source for generating broadband light of dominant wavelength from about 420 nm to about 480 nm and a FWHM from 25 nm to 50 nm; a first photoluminescence material for generating light with a peak emission wavelength from 490 nm to 550 nm; and a second photoluminescence material for generating light with a peak emission wavelength from 600 nm to 680 nm; wherein the broadband light generated by the broadband solid-state light source is composed of a combination of multiple narrowband light emissions, and wherein the camera flash generates white light having a Correlated Color Temperature and an intensity versus wavelength spectrum, which over a wavelength range 460 nm to 600 nm, a maximum percentage deviation between the normalized intensity of the full spectrum white light emitted by the device compared with the normalized intensity of light of a black-body spectrum or CIE Standard Illuminant D of the same Correlated Color Temperature is less than ±30%. The maximum percentage deviation may be less than ±20% and may be less than ±10%. It may be that the camera flash generates white light with a color temperature from 5000K to 6500K.

## BRIEF DESCRIPTION OF THE DRAWINGS

These and other aspects and features of the present invention will become apparent to those ordinarily skilled in the art upon review of the following description of specific embodiments of the invention in conjunction with the accompanying figures, wherein:

FIGS. **1a** and **1b** show a remote phosphor full spectrum white light emitting device;

FIG. **2a** is a schematic of a broadband blue solid-state excitation source for use in the full spectrum white light emitting device of **FIGS. 1a** and **1b**;

FIG. **2b** is a schematic of a broadband blue solid-state excitation source for use in the full spectrum white light emitting device of **FIGS. 1a** and **1b**;

FIG. **3a** is a schematic cross-sectional view of a full spectrum white light emitting device;

FIG. **3b** is a schematic cross-sectional view of a full spectrum white light emitting device;

FIGS. **4a** and **4b** is a schematic of a full spectrum white light emitting device;

FIG. **5** are spectra, normalized intensity I versus wavelength (nm), for (i) a spectrum denoted **A** (dotted line) for a known full spectrum light emitting device that utilizes a narrowband excitation source, (ii) a spectrum denoted **B** (thin solid line) for a full spectrum light emitting device that utilizes a broadband excitation source (iii) black-body curve (bbc) (dashed line) for a CCT that is nominally the same as that of spectra **A** and **B,** and (iv) the Circadian Action Spectrum (CAS) - thick solid line, Relative Quantum Sensitivity versus wavelength (nm);

FIG. **6** are emission spectra, normalized intensity (normalized to a CIE 1931 XYZ relative luminance Y=100) versus wavelength (nm) for (i) Dev.1 (solid line), (ii) Dev.2 (thick dashed line), (iii) Com.1 (dotted line), and (iv) Planckian spectrum (thin dashed line) for a CCT of 2700K that is nominally the same as Dev.1, Dev.2, and Com.1;

FIG. **7a** are emission spectra, normalized intensity (normalized to a CIE 1931 XYZ relative luminance Y=100) versus wavelength (nm) for (i) Dev.3 (solid line), (ii) Dev.4 (thick dashed line), (iii) Dev.5 (dash dot line), (iv) Com.2 (dotted line), and (v) Planckian spectrum (thin dashed line) for a CCT of 3000K that is nominally the same as Dev.3, Dev.4, Dev.5 and Com.2;

FIG. **7b** are emission spectra, normalized intensity (normalized to a CIE 1931 XYZ relative luminance Y=100) versus wavelength (nm) for (i) Dev.4 (solid line), (ii) Com.2 (dotted line), and (iii) Planckian spectrum (dashed line) for a CCT of 3000K that is nominally the same as Dev.4 and Com.2;

**FIG. 7c** are emission spectra, normalized intensity (normalized to a CIE 1931 XYZ relative luminance Y=100) versus wavelength (nm) for (i) Dev.5 (solid line), (ii) Com.3 (dotted line), and (iii) Planckian spectrum (dashed line) for a CCT of 3000K that is nominally the same as Dev.5 and Com.3;

**FIG. 8** are emission spectra, normalized intensity (normalized to a CIE 1931 XYZ relative luminance Y=100) versus wavelength (nm) for (i) Dev.6 (solid line), (ii) Com.4 (dotted line), and (iii) Planckian spectrum (dashed line) for a CCT of 4000K that is nominally the same as Dev.6 and Com.4;

**FIG. 9a** are emission spectra, normalized intensity (normalized to a CIE 1931 XYZ relative luminance Y=100) versus wavelength (nm) for (i) Dev.7 (solid line), (ii) Com.5 (dotted line), and (iii) Planckian spectrum (dashed line) for a CCT of 5000K that is nominally the same as Dev.7 and Com. 5;

**FIG. 9b** are emission spectra, normalized intensity (normalized to a CIE 1931 XYZ relative luminance Y=100) versus wavelength (nm) for (i) Dev.8 (solid line), (ii) Com.6 (dotted line), and (iii) Planckian spectrum (dashed line) for a CCT of 5000K that is nominally the same as Dev.8 and Com.6.

**FIGS. 10a** to **10d** are schematic representations of a CSP (Chip Scale Packaged) full spectrum white light emitting device according to an embodiment of the invention in which: **FIG. 10a** shows a side view, **FIG. 10b** shows a top view, **FIG. 10c** shows a bottom view, and **FIG. 10d** shows an end view;

**FIG. 11** is a sectional side view of a CSP full spectrum white light emitting device in accordance with an embodiment of the invention;

**FIGS. 12a** to **12d** are schematic representations of a CSP full spectrum white light emitting device according to an embodiment of the invention in which: **FIG. 12a** shows a sectional side view through A-A, **FIG. 12b** shows a top view, **FIG. 12c** shows a bottom view, and **FIG. 12d** shows a sectional end view through B-B;

**FIG. 13** is a sectional side view of a CSP full spectrum white light emitting device in accordance with an embodiment of the invention;

**FIGS. 14a** to **14d** are schematic representations of a CSP full spectrum white light emitting device according to an embodiment of the invention in which: **FIG. 14a** shows a sectional side view through A-A, **FIG. 14b** shows a top view, **FIG. 14c** shows a bottom view, and **FIG. 14d** shows a sectional end view through B-B;

**FIG. 15** is a sectional side view of a CSP full spectrum white light emitting device in accordance with an embodiment of the invention;

**FIGS. 16a** to **16g** illustrate a method of manufacture of the CSP full spectrum white light emitting devices of **FIGS. 14a** to **14d** and **FIG. 15;**

**FIGS. 17a** to **17d** are schematic representations of a CSP full spectrum white light emitting device according to an embodiment of the invention in which: **FIG. 17a** shows a sectional side view through A-A, **FIG. 17b** shows a top view, **FIG. 17c** shows a bottom view, and **FIG. 17d** shows a sectional end view through B-B;

**FIG. 18** is a sectional side view of a CSP full spectrum white light emitting device in accordance with an embodiment of the invention;

**FIGS. 19a** to **19g** illustrate a method of manufacture of the CSP full spectrum white light emitting device of **FIGS. 17a to 17d;** and

**FIG. 20** is a schematic representation of a sectional side view of CSP full spectrum white light emitting device according to an embodiment of the invention.

DETAILED DESCRIPTION OF THE INVENTION

Embodiments of the present invention will now be described in detail with reference to the drawings, which are provided as illustrative examples of the invention to enable those skilled in the art to practice the invention. Notably, the figures and examples below are not meant to limit the scope of the present invention to a single embodiment, but other embodiments are possible by way of interchange of some or all the described or illustrated elements. Moreover, where certain elements of the present invention can be partially or fully implemented using known components, only those portions of such known components that are necessary for an understanding of the present invention will be described, and detailed descriptions of other portions of such known components will be omitted so as not to obscure the invention. In the present specification, an embodiment showing a singular component should not be considered limiting; rather, the invention is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present invention encompasses present and future known equivalents to the known components referred to herein by way of illustration.

Throughout this specification, like reference numerals preceded by the figure number are used to denote like features.

Embodiments of the invention concern white light emitting devices that comprise a broadband solid-state excitation source, for example one or more LEDs, that is operable to generate broadband blue excitation light with a dominant wavelength in a range from 420 nm to 480 nm. In this patent specification "broadband" blue light is used to denote blue light that has a FWHM (Full Width Half Maximum) at least 25 nm, preferably at least 30 nm; or may be used to denote blue light that is composed of a combination of at least two different wavelength blue light emissions in a wavelength range 420 nm to 480 nm. More particularly, although not exclusively, embodiments of the invention concern white light emitting devices for generating full spectrum white light that closely resembles natural light in the blue to cyan region of the visible spectrum (about 430 nm to about 520 nm).

## Remote phosphor full spectrum white light emitting devices

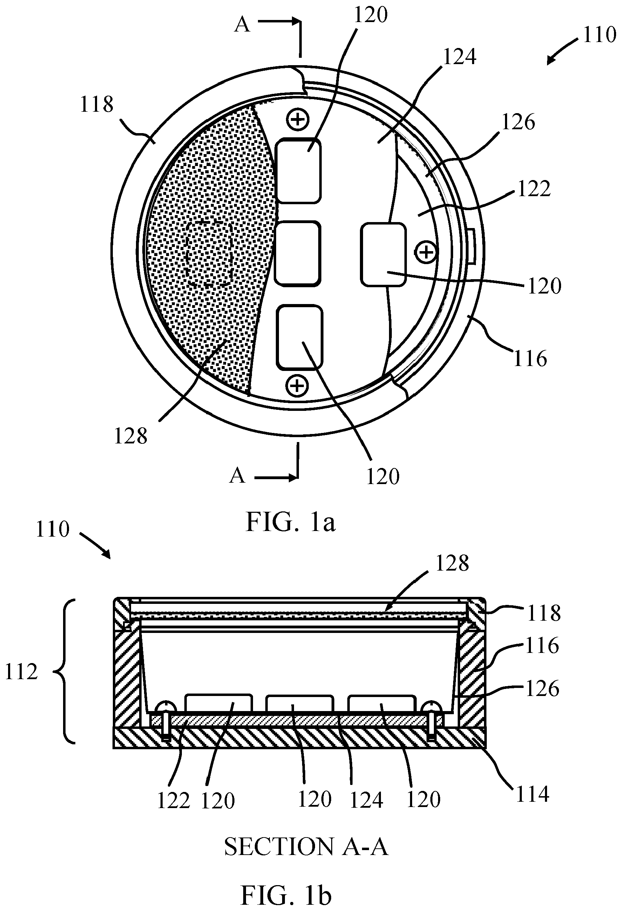

FIGS. **1a** and **1b** illustrate a remote phosphor solid-state full spectrum white light emitting device in which FIG. **1a** is a partial cross-sectional plan view and FIG. **1b** is a sectional view through A-A. The device **110** is configured to generate full spectrum white light with a CCT (Correlated Color Temperature) of between 1800K and 6800K. The device can be used alone or comprise a part of a downlight or other lighting arrangement. The device **110** comprises a hollow cylindrical body **112** composed of a circular disc-shaped base **114,** a hollow cylindrical wall portion **116** and a detachable annular top **118**. To aid in the dissipation of heat, the base **114** is preferably fabricated from aluminum, an alloy of aluminum or any material with a high thermal conductivity. The base **114** can be attached to the wall portion **116** by screws or bolts or by other fasteners or by means of an adhesive.

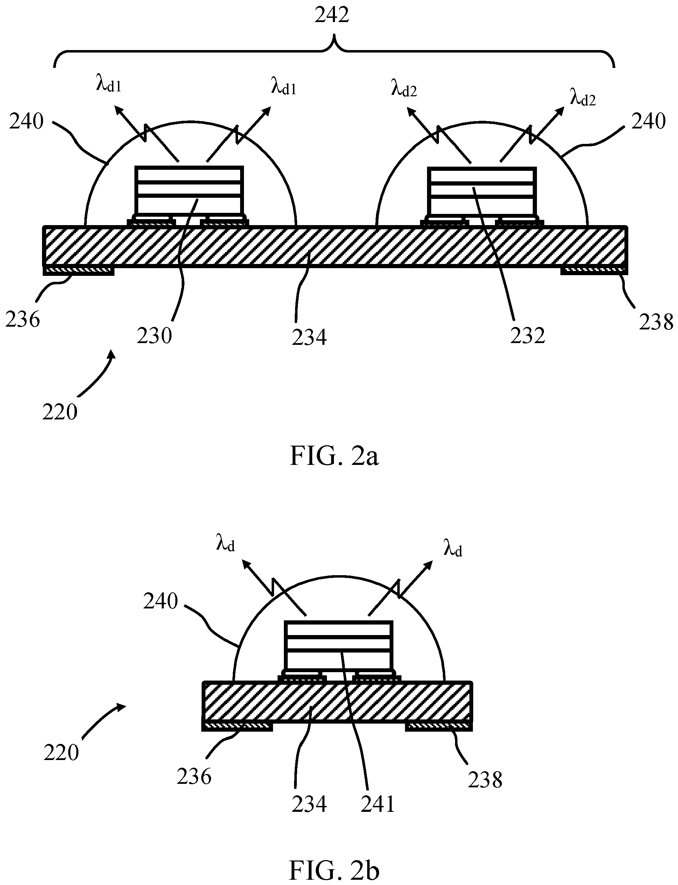

The device **110** further comprises a plurality (five in the example of FIGS. **1a** and **1b**) of broadband blue solid-state excitation sources **120** that are mounted in thermal communication with a circular-shaped MCPCB (metal core printed circuit board) **122.** Various embodiments of the broadband blue solid-state excitation sources **120** are illustrated in FIGS. **2a** to **4b**. To maximize the emission of light, the device **10** can further comprise light reflective surfaces **124** and **126** that respectively cover the face of the MCPCB **122** and the inner curved surface of the cylindrical wall **116**.

The device **110** further comprises a photoluminescence wavelength conversion component **128** that is located remotely to the excitation sources **120** and operable to absorb a portion of the excitation light generated by the excitation sources **120** and convert it to light of a different wavelength by a process of photoluminescence. The emission product of the device **110** comprises the combined light generated by the broadband blue excitation sources **120** and photoluminescence light generated by the photoluminescence wavelength conversion component **128**. The photoluminescence wavelength conversion component may be formed of a light transmissive material (for example, polycarbonate, acrylic material, silicone material, etc.) that incorporates a mixture of a yellow, red and/or green phosphor. Furthermore, in embodiments, the photoluminescence wavelength conversion component may be formed of a light transmissive substrate that is coated with phosphor material(s). The wavelength conversion component **128** is positioned remotely to the excitation sources **120** and is spatially separated from the excitation sources. In this patent specification, "remotely" and "remote" means in a spaced or separated relationship. Typically, wavelength conversion component and excitation sources are separated by an air, while in other embodiments they can be separated by a suitable light transmissive medium, such as for example a light transmissive silicone or epoxy material. The wavelength conversion component **128** is configured to completely cover the housing opening such that all light emitted by the lamp passes through the wavelength component **128**. As shown, the wavelength conversion component **128** can be detachably mounted to the top of the wall portion **116** using the top **118** enabling the component and emission color of the lamp to be readily changed.

FIG. **2a** is a schematic representation of a broadband blue solid-state excitation source **220**. The broadband blue solid-state excitation source **220** is configured to generate broadband blue excitation light with a dominant wavelength in a range 420 nm to 470 nm, that is, in the blue region of the visible spectrum. In this embodiment, it also has a FWHM in a range 25 nm to 50 nm. In accordance with an embodiment of the invention, the broadband blue solid-state excitation source **220** comprises a first solid-state light source **230** and a second solid-state light source **232,** which in this example are narrowband blue LED chips (e.g., blue-emitting GaN -based LED chips). The first solid-state light source **230** generates a blue light emission having a first dominant wavelength $\lambda_{d1}$ in a range from 420 nm to 470 nm and the second solid-state light source **232** generates a blue light emission having a second dominant wavelength $\lambda_{d2}$ in a range from 420 nm to 470 nm. The first and second solid-state light sources are selected such that the dominant wavelengths of light generated by the sources are different (i.e., $\lambda_{d1}$ is different to $\lambda_{d2}$). The combination of light from the first and second solid-state light sources **230/232** constitutes the broadband blue excitation light output **242** of the broadband blue solid-state excitation source **220** and has a dominant wavelength in a range 420 nm to 470 nm and has a FWHM in a range 25 nm to 50 nm. It will be understood that in other embodiments the solid-state excitation source may comprise a single solid-state light source. In this specification, a single solid-state light source is defined as one or more solid-state light sources each of which generates light with the same (i.e., single/solitary) dominant wavelength and with a FWHM of at least 25nm.

As indicated in FIG. **2a,** the broadband blue solid-state excitation source **220** can comprise a surface mountable device (SMD), such as for example an SMD 2835 LED package, in which the first and second solid-state light sources are flip chip bonded on a top face of a substrate **234**. Electrical contacts **236, 238** can be provided on the bottom face of the substrate **234** for operating the excitation source. The first and second solid-state light sources **230, 232** can be encapsulated with a light transmissive optical encapsulant **240,** such as for example a silicone or epoxy material.

FIG. **2b** is a schematic representation of a broadband blue solid-state excitation source **220.** The solid-state excitation source **220** is configured to generate excitation light with a dominant wavelength in a range 420 nm to 470 nm, that is, in the blue region of the visible spectrum. In this embodiment, it also has a FWHM in a range 25 nm to 50 nm. In accordance with an embodiment of the invention, the solid-state excitation source **220** comprises a broadband solid-state light source 241, which in this example is a single broadband LED such as for example an InGaN/GaN blue LED having an active region with multiple-quantum-wells (MQWs), as disclosed in Appl. Phys. lett. 75, 1494 (1999) Tran C A et al. entitled "Growth of InGaN multiple-quantum-well blue light-emitting diodes on silicone by metal organic vapor phase epitaxy". The broadband solid-state light source **241** generates broadband blue light comprising multiple overlapping blue light emissions of peak wavelengths in a range from 420 nm to 470 nm. Thus, the single solid-state light source **241** generates light with a single/solitary dominant wavelength and with a FWHM of at least 25nm.

As indicated in FIG. **2b,** the solid-state excitation source **220** can comprise a surface mountable device (SMD), such as for example an SMD 2835 LED package, in which the solid-state light source is flip chip bonded on a top face of a substrate **234.** Electrical contacts **236, 238** can be provided on the bottom face of the substrate **234** for operating the excitation source. The solid-state light source **241** can be encapsulated with a light transmissive optical encapsulant **240,** such as for example a silicone or epoxy material.

Packaged full spectrum white light emitting devices

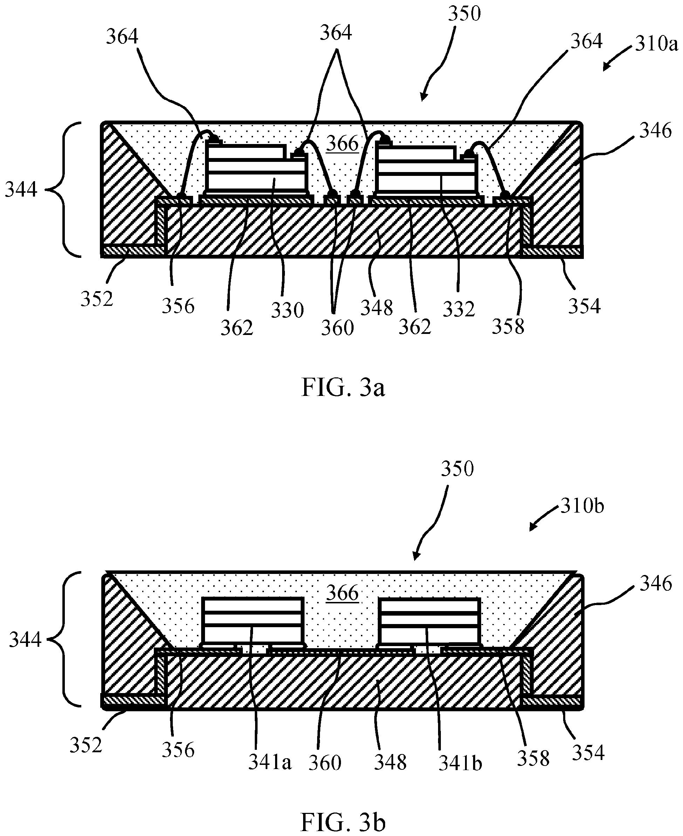

FIG. **3a** is a schematic cross-sectional representation of a packaged full spectrum white light emitting device **310a.** The device **310a** is configured to generate full spectrum white light with a CCT (Correlated Color Temperature) of in a range 1800 K to 6800K.

The device **310a** comprises a broadband blue solid-state excitation source constituted by first and second solid-state light sources **330, 332,** for example blue-emitting GaN (gallium nitride)-based LED chips, that are housed within a package **344.** In a similar/same manner as described above, the first solid-state light source **330** can generate a blue light emission having a first dominant wavelength $\lambda_{d1}$ in a range from 420 nm to 470 nm and the second solid-state light source **332** can generate a blue light emission having a second dominant wavelength $\lambda_{d2}$ in a range from 420 nm to 470 nm. The dominant wavelength $\lambda_{d1}$ of the first solid-state light source is different from the dominant wavelength $\lambda_{d2}$ of the second solid-state light source. The package, which can for example comprise Surface Mountable Device (SMD) such as an SMD 2835 LED package, comprising upper portion **346** and base portion **348.** The upper body part **346** defines a recess **350** which is configured to receive the solid-state light sources **330, 332.** The package **344** can further comprise electrical connectors **352** and **354** on an exterior face of the base of the package **344.** The electrical connectors **352, 354** can be electrically connected to electrode contact pads **356, 358** and **360** on the floor of the recess **350.** Using adhesive or solder, the solid-state light sources (LED chips) **330, 332** can be mounted to a thermally conductive pad **362** located on the floor of the recess **350.** The LED chip's electrode pads can be electrically connected to corresponding electrode contact pads **356, 358** and **360** on the floor of the package **344** using bond wires **362.** Alternatively, the LED chips can be flip chip mounted in and electrically connected to the package. The recess **350** is filled with a light transmissive optical encapsulant **364,** typically an optically clear silicone, which is loaded with a mixture of photoluminescence materials such that the exposed surfaces of the LED chips **330, 332** are covered by the photoluminescence/silicone material mixture. To enhance the emission brightness of the device the walls of the recess **350** can be inclined and have a light reflective surface. Of course, it will be understood that in other embodiments the one or more solid-state light sources (LED chips **330, 332**) each generate light with the same (i.e. single/solitary) dominant wavelength and with a FWHM of at least 25nm.

FIG. **3b** is another embodiment of the present invention. It is like FIG. **3a** except that the first and second narrowband solid-state light sources are replaced by two broadband blue LEDs **341a/341b** having an active region with multiple-quantum-wells. Typically, the first and second broadband blue solid-state light sources **341a/341b** each generate broadband blue excitation light having dominant wavelengths $k_d$ which are the same.

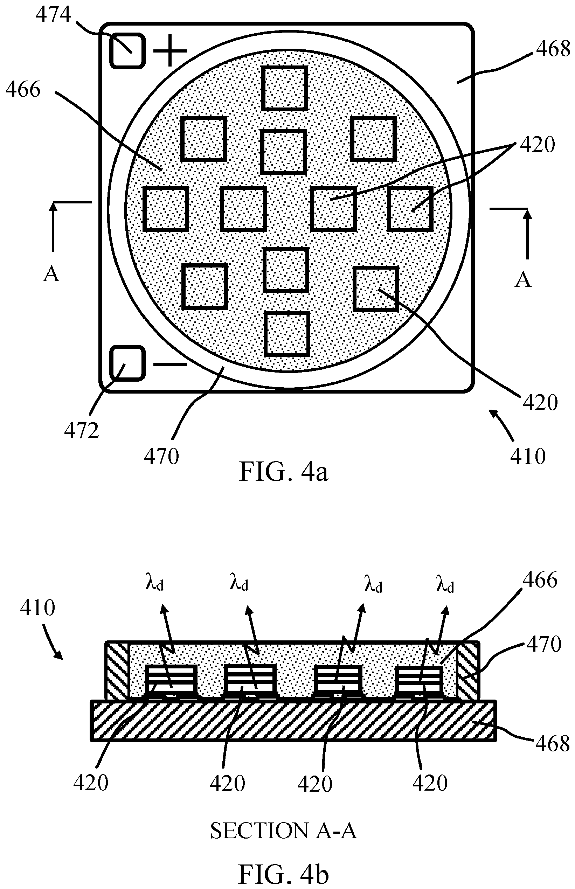

FIGS. **4a** and **4b** illustrate a Chip On Board (COB) packaged full spectrum white light emitting device **410** in which FIG. **4a** is a plan view and FIG. **4b** is a sectional view through A-A. The device **410** is configured to generate warm white light with a CCT (Correlated Color Temperature) of between 2500K and 5000K and a CRI (Color Rendering Index) of greater than 95.

The device **410** comprises a plurality (twelve in the example of FIG. **4a**) broadband blue solid-state excitation sources **420,** for example broadband blue-emitting GaN (gallium nitride)-based LED flip chip dies, mounted in thermal communication with a square-shaped MCPCB **468.**

As indicated in FIG. **4a,** the excitation sources **420** can be configured as a generally circular array. The solid-state excitation sources (broad-band LED dies) **420** can each generate excitation light having a dominant wavelength $\lambda_d$ in a range from 440 nm to 455 nm. In this embodiment, they have a FWHM (Full Width Half Maximum) in a range 25 nm to 50 nm. Electrical contacts **472, 474** can be provided on the top face of the MCPCB **468** for operating the white light emitting device **410.** As shown, the broad-band LED flip chip dies **420** are encapsulated with a light transmissive optical encapsulant **466,** such as for example a silicone or epoxy material, which is loaded with a mixture of photoluminescence materials such that the exposed surfaces of the LED dies **420** are covered by the photoluminescence/silicone material mixture. As shown, the light transmissive encapsulant/photoluminescence material mixture **466** can be contained within an annular-shaped wall **470**. Of course, it will be understood that in other embodiments, the arrangement depicted in FIGS. **4a** and **4b** could comprise solid-state excitation sources **420** constituted by two or more LEDs rather than a single broadband InGaN/GaN blue LED having an active region with multiple-quantum-wells.

Green to yellow photoluminescence materials

In this patent specification, a green to yellow photoluminescence material refers to a material which generates light having a peak emission wavelength ($\lambda_{pe}$) in a range ~490 nm to ~570 nm, that is in the green to yellow region of the visible spectrum. Preferably, the green to yellow photoluminescence material has a broad emission characteristic and preferably has a FWHM (Full Width Half Maximum) of ~100 nm or wider. The green to yellow photoluminescence material can comprise any photoluminescence material, such as for example, garnet-based inorganic phosphor materials, silicate phosphor materials and oxynitride phosphor materials. Examples of suitable green to yellow phosphors are given in **Table 1.**

In some embodiments, the green to yellow photoluminescence materials comprises a cerium-activated yttrium aluminum garnet phosphor of general composition $Y_3(Al,Ga)_5O_{12}:Ce$ (YAG) such as for example a YAG series phosphor from Intematix Corporation, Fremont California, USA which have a peak emission wavelength of in a range 527 nm to 543 nm and a FWHM of ~120 nm. In this patent specification, the notation YAG# represents the phosphor type - YAG - based phosphors - followed by the peak emission wavelength in nanometers (#). For example, YAG535 denotes a YAG phosphor with a peak emission wavelength of 535 nm. The green to yellow photoluminescence material may comprise a cerium-activated yttrium aluminum garnet phosphor of general composition $(Y,Ba)_3(Al,Ga)_5O_{12}:Ce$ (YAG) such as for example a GNYAG series phosphor from Intematix Corporation, Fremont California, USA. In some embodiments, the green photoluminescence material can comprise an aluminate (LuAG) phosphor of general composition $Lu_3Al_5O_{12}:Ce$ (GAL). Examples of such phosphors include for example the GAL series of phosphor from Intematix Corporation, Fremont California, USA which have a peak emission wavelength of 516 nm to 560 nm and a FWHM of ~120 nm. In this patent specification, the notation GAL# represents the phosphor type (GAL) - LuAG - based phosphors - followed by the peak emission wavelength in nanometers (#). For example, GAL520 denotes a GAL phosphor with a peak emission wavelength of 520 nm.

Examples of green to yellow silicate phosphors include europium activated orthosilicate phosphors of general composition $(Ba, Sr)_2SiO4: Eu$ such as for example G, EG, Y and EY series of phosphors from Intematix Corporation, Fremont California, USA which have a peak emission wavelength in a range 507 nm to 570 nm and a FWHM of ~70 nm to ~80 nm.

In some embodiments, the green to yellow phosphor can comprise a green-emitting oxynitride phosphor as taught in United States Patent US 8,679,367 entitled "*Green-Emitting (Oxy) Nitride-Based Phosphors and Light Emitting Devices Using the Same*" which is hereby incorporated in its entirety. Such a green-emitting oxynitride (ON) phosphor can have a general composition $Eu^{2+}:M^{2+}Si_4AlO_xN_{(7-2x/3)}$ where $0.1 \leq x \leq 1.0$ and $M^{2+}$ is one or more divalent metal selected from the group consisting of Mg, Ca, Sr, Ba, and Zn. In this patent specification, the notation ON# represents the phosphor type (oxynitride) followed by the peak emission wavelength ($\lambda_{pe}$) in nanometers (#). For example, ON495 denotes a green oxynitride phosphor with a peak emission wavelength of 495 nm.

| Table 1 | | | |
|---|---|---|---|
| Example green to yellow photoluminescence materials | | | |
| Phosphor | General Composition | | Wavelength $\lambda_{\rho e}$ (nm) |
| YAG (YAG#) | $Y_{3-x}(Al_{1-y}Ga_y)_5O_{12}:Ce_x$ | 0.01<x<0.2 & 0<y<2.5 | 520 - 570 |
| GNYAG (YAG#) | $(Y,Ba)_{3-x}(Al_{1-y}Ga_y)5O_{12}:Ce_x$ | 0.01<x<0.2 & 0<y<2.5 | 520 - 550 |
| LuAG (GAL#) | $Lu_{3-x}(Al_{1-y}M_y)_5O_{12}:Ce_x$ | 0.01<x<0.2 & 0<y<1.5 M = Mg, Ca, Sr, Ba, Ga, | 500 - 550 |
| LuAG (GAL#) | $Lu_{3-x}(Al_{1-y}Ga_y)_5O_{12}:Ce_x$ | 0.01 <x<0.2 & 0<y<1.5 | 500 - 550 |
| Silicate | $A_2SiO_4:Eu$ | A = Mg, Ca, Sr, Ba | 500 - 575 |
| Silicate | $(Sr_{1-x}Ba_X)_2SiO_4:Eu$ | 0.3<x<0.9 | 500 - 575 |

Orange to red photoluminescence materials

The orange to red photoluminescence material can comprise any orange to red photoluminescence material, typically a phosphor, that is excitable by blue light and operable to emit light with a peak emission wavelength $\lambda_{pe}$ in a range about 600 nm to about 670 nm and can include, for example, a europium activated silicon nitride-based phosphor, $\alpha$-SiAlON, Group IIA/IIB selenide sulfide-based phosphor or silicate-based phosphors. Examples of orange to red phosphors are given in **Table 2.**

In some embodiments, the europium activated silicon nitride-based phosphor comprises a Calcium Aluminum Silicon Nitride phosphor (CASN) of general formula $CaAlSiN_3:Eu^{2+}$. The CASN phosphor can be doped with other elements such as strontium (Sr), general formula $(Sr,Ca)AlSiN_3:Eu^{2+}$. In this patent specification, the notation CASN# represents the phosphor type (CASN) followed by the peak emission wavelength ($\lambda_{pe}$) in nanometers (#). For example, CASN615 denotes an orange to red CASN phosphor with a peak emission wavelength of 615 nm.

In one embodiment, the orange to red phosphor can comprise an orange to red-emitting phosphor as taught in United States Patent US 8,597,545 entitled "*Red-Emitting Nitride-Based Calcium-Stabilized Phosphors*" which is hereby incorporated in its entirety. Such a red emitting phosphor comprises a nitride-based composition represented by the chemical formula $M_aSr_bSi_cAl_dN_eEu_f$, wherein: M is Ca, and $0.1 \leq a \leq 0.4$; $1.5 < b < 2.5$; $4.0 \leq c \leq 5.0$; $0.1 \leq d \leq 0.15$; $7.5 < e < 8.5$; and $0 < f < 0.1$; wherein $a+b+f > 2+d/v$ and v is the valence of M.

Alternatively, the orange to red phosphor can comprise an orange to red emitting nitride-based phosphor as taught in United States Patent US 8,663,502 entitled "*Red-Emitting Nitride-Based Phosphors*" which is hereby incorporated in its entirety. Such a red emitting phosphor comprising a nitride-based composition represented by the chemical formula $M_{(x/v)}M'_2Si_{5-x}Al_xN_8$ :RE, wherein: M is at least one monovalent, divalent or trivalent metal with valence v; M' is at least one of Mg, Ca, Sr, Ba, and Zn; and RE is at least one of Eu, Ce, Tb, Pr, and Mn; wherein x satisfies $0.1 \leq x < 0.4$, and wherein said red-emitting phosphor has the general crystalline structure of $M'_2Si_5N_8$:RE, Al substitutes for Si within said general crystalline structure, and M is located within said general crystalline structure substantially at the interstitial sites. An example of one such a phosphor is XR610 red nitride phosphor from Intematix Corporation, Fremont California, USA which has a peak emission wavelength of 610 nm.

Orange to red phosphors can also include Group IIA/IIB selenide sulfide-based phosphors. A first example of a Group IIA/IIB selenide sulfide-based phosphor material has a composition $MSe_{1-x}S_x:Eu$, wherein M is at least one of Mg, Ca, Sr, Ba and Zn and $0 < x < 1.0$. A particular example of this phosphor material is CSS phosphor ($CaSe_{1-x}S_x:Eu$). Details of CSS phosphors are provided in co-pending United States patent application Publication Number US2017/0145309 filed 30 September 2016, which is hereby incorporated by reference in its entirety. The CSS orange to red phosphors described in United States patent publication US2017/0145309 can be used in the present invention. The emission peak wavelength of the CSS phosphor can be tuned from 600 nm to 650 nm by altering the S/Se ratio in the composition and exhibits a narrow-band red emission spectrum with FWHM in the range ~ 48 nm to ~ 60 nm (longer peak emission wavelength typically has a larger FWHM value). In this patent specification, the notation CSS# represents the phosphor type (CSS) followed by the peak emission wavelength in nanometers (#). For example CSS615 denotes a CSS phosphor with a peak emission wavelength of 615 nm. To improve reliability, the CSS phosphor particles can be coated with one or more oxides, for example: aluminum oxide ($Al_2O_3$), silicon oxide ($SiO_2$), titanium oxide ($TiO_2$), zinc oxide (ZnO), magnesium oxide (MgO), zirconium oxide ($ZrO_2$), boron oxide ($B_2O_3$) or chromium oxide (CrO). Alternatively and/or in addition, the narrow-band red phosphor particles may be coated with one or more fluorides, for example: calcium fluoride ($CaF_2$), magnesium fluoride ($MgF_2$), zinc fluoride ($ZnF_2$), aluminum fluoride ($AlF_3$) or titanium fluoride ($TiF_4$). The coatings may be a single layer, or multiple layers with combinations of the aforesaid coatings. The combination coatings may be coatings with an abrupt transition between the first and second materials, or may be coatings in which there is a gradual/smooth transition from the first material to the second material thus forming a zone with mixed composition that varies through the thickness of the coating.

In some embodiments, the orange to red phosphor can comprise an orange-emitting silicate-based phosphor as taught in United States Patent US 7,655,156 entitled "*Silicate-Based Orange Phosphors*" which is hereby incorporated in its entirety. Such an orange-emitting silicate-based phosphor can have a general composition $(Sr_{1-x}M_x)_yEu_zSiO_5$ where $0 < x \leq 0.5$, $2.6 \leq y \leq 3.3$, $0.001 \leq z \leq 0.5$ and M is one or more divalent metal selected from the group consisting of Ba, Mg, Ca, and Zn. In this patent specification, the notation O# represents the phosphor type (orange silicate) followed by the peak emission wavelength ($\lambda_{pe}$) in nanometers (#). For example, O600 denotes an orange silicate phosphor with a peak emission wavelength of 600 nm.

**Table 2**

| Example orange to red photoluminescence materials | | | |
| --- | --- | --- | --- |
| Phosphor | General Composition | | Wavelength $\lambda_{\rho e}$ (nm) |
| CASN (CASN#) | $(Ca_{1-x}Sr_x)AlSiN_3{:}Eu$ | $0.5 < x \leq 1$ | 600 - 660 |
| 258 nitride | $Ba_{2-x}Sr_xSi_5N_8{:}Eu$ | $0 \leq x \leq 2$ | 580 - 630 |
| Group IIA/IIB Selenide Sulfide (CSS#) | $MSe_{1-x}S_x{:}Eu$ | M=Mg, Ca, Sr, Ba, Zn $0 < x < 1.0$ | 600-650 |
| CSS (CSS#) | $CaSe_{1-x}S_x{:}Eu$ | $0 < x < 1.0$ | 600-650 |
| Silicate (O#) | $(Sr_{1-x}M_x)_yEu_zSiO_5$ | M = Ba, Mg, Ca, Zn $0 < x \leq 0.5$ $2.6 \leq y \leq 3.3$ $0.001 \leq z \leq 0.5$ | 565 - 610 |

## 1800K to 6800K full spectrum white light emitting devices

As described above, embodiments of the invention concern full spectrum white light emitting devices that generate full spectrum light that closely resembles natural light, in particular although not exclusively, in the in blue to cyan (430 nm to 520 nm) region of the visible spectrum where human non-visual perception, as for example, measured by CAF (Circadian Action Factor) are affected most. According to other aspects, the invention concerns improving the efficacy of full spectrum white light emitting devices while maintaining the spectrum close to the natural light in the wavelength ranging from about 430 nm to about 520 nm. The inventors have discovered that the efficacy of full spectrum white light emitting device can be improved by optimizing (reducing) the energy content in the red region of the spectrum, in particular the energy content corresponding to the "Saturated Red" - CRI R9 and "Reddish Purple" - CRI R8 while maintaining the spectral content corresponding to the blue and cyan regions (430 nm to 520 nm) to closely resemble natural light. Such an improvement in efficacy can be achieved by configuring the device such that it generates full spectrum white light having a spectrum with an intensity roll-off (tail) in the orange to red region of the visible spectrum that decreases (drops) to half its maximum intensity in a wavelength range from about 645 nm to about 695 nm).

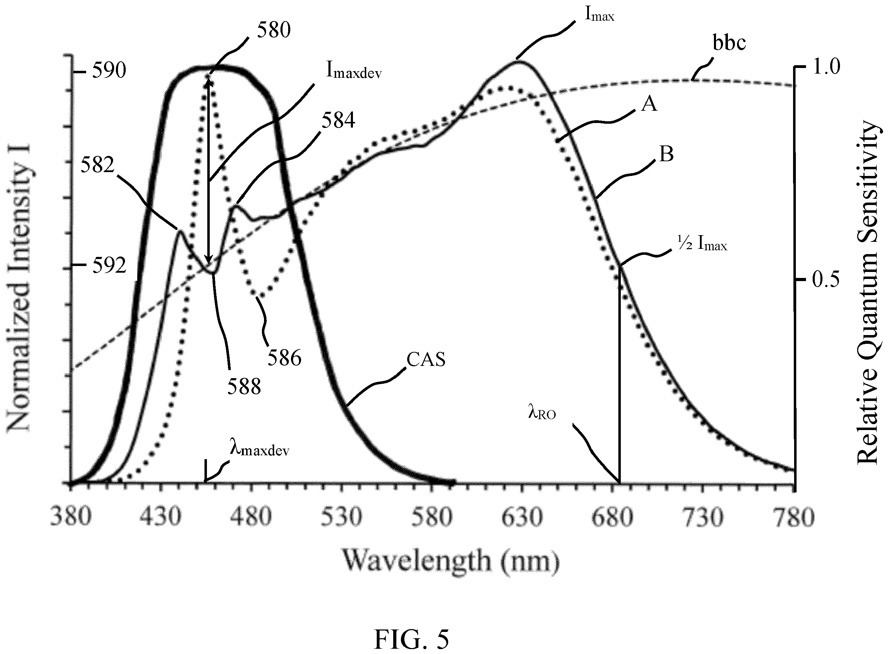

FIG. **5** are spectra, normalized intensity I versus wavelength (nm) for (i) a spectrum denoted **A** (dotted line) for a known full spectrum light emitting device that utilizes a narrowband excitation source, (ii) a spectrum denoted **B** (thin solid line) for a full spectrum light emitting device in accordance with the invention that utilizes a broadband excitation source (iii) black-body curve (bbc) (dashed line) for a CCT that is nominally the same as that of spectra **A** and **B,** and (iv) the Circadian Action Spectrum (CAS) - thick solid line, Relative Quantum Sensitivity versus wavelength (nm). The figure defines various parameters used in the patent specification and illustrates the principle of the invention.

Referring to **FIG. 5,** the Circadian Action Spectrum (CAS), also referred to as spectral circadian efficiency function $c(\lambda)$, represents human non-visual relative sensitivity to light. The maximum sensitivity of c(k) occurs at a wavelength of 460 nm. The CAS suggests that the 430 nm to 520 nm portion of the spectrum as being the most significant wavelengths for providing circadian input for regulating melatonin secretion.

Visually comparing the spectrum **A** with the back-body curve (bbc), it will be noted that spectrum **A** exhibits a peak **580,** corresponding to the excitation light generated by the narrowband excitation source, whose intensity deviates significantly from that of the bbc (i.e. peak intensity is very much higher than that of the bbc at the same wavelength). In comparison, spectrum **B** exhibits two peaks **582, 584,** corresponding to the excitation light generated by the broadband excitation source whose intensity, compared with spectrum **A,** deviates only slightly from that of the bbc (i.e. the peak intensities are slightly higher than the bbc at the same wavelengths). It is to be further noted that the peak **580** occurs at a wavelength of 455 nm that is close to the maximum sensitivity of the CAS which is at a wavelength of 460 nm. Moreover, it is to be noted that spectrum **A** exhibits a trough (valley) **586** whose minimum intensity deviates significantly from that of the bbc (i.e., the trough intensity is much lower than the bbc). In comparison, spectrum **B** exhibits a trough (valley) **588** that whose minimum intensity, compared with spectrum **A,** deviates only slightly from that of the bbc (i.e., the trough intensity is slight lower than the bbc). As can be seen from the figure, the smaller deviation of emission peaks **582** and **584** of spectrum **B** (compared with peak **584** of spectrum **A**) and the smaller deviation of trough **588** of spectrum **B** (compared with trough **586** of spectrum **A**) from the bbc indicates that spectrum **B** more closely resembles the bbc (Planckian spectrum) over a wavelength range 430 nm to 520 nm (blue to cyan). It will be further appreciated that spectrum **B** more closely resembles natural light over this wavelength region where human non-visual perception measured by CAP (Circadian Action Factor) are affected most and this can be beneficial to human wellbeing.

A metric for quantifying how closely the spectrum resembles the bbc is a maximum (largest) percentage intensity deviation ($I_{maxdev}$) from the intensity of light of the bbc of the same Correlated Color Temperature. That is, over a wavelength range from about 430 nm to 520 nm, $I_{maxdev}$ is the maximum (largest) percentage intensity difference between the intensity of the spectrum and the intensity of the bbc. The maximum deviation can be positive (such as a peak where the spectrum intensity is greater than the bbc) or negative (such as a trough where the spectrum intensity is less than the bbc). To make a meaningful comparison of the spectra, each spectra is normalized to have the same CIE 1931 XYZ relative luminance Y. The spectrum is normalized using the photopic luminosity function $y(\lambda)$ - sometimes referred to as the photopic or visual luminous efficiency function $v(\lambda)$ - of a standard observer which takes account of the photopic (visual) response of an observer and are for the same correlated color temperature. $I_{maxdev}$ is thus the maximum (greatest) percentage intensity difference between the normalized intensity of the spectrum and the normalized intensity of the bbc over a wavelength range from about 430 nm to 520 nm. $I_{maxdev}$ is defined as:

$$I_{maxdev} = \left[ \frac{\text{Intensity of spectrum at } \lambda_{maxdev} \text{ x } 100}{\text{Intensity of bbc at } \lambda_{maxdev}} \right] - 100$$

For example, referring to FIG. **5,** for spectrum **A** the maximum deviation of the spectrum from the bbc corresponds to peak **580** at a wavelength $\lambda_{maxdev}$ = 455 nm. The intensity of the spectrum at $\lambda_{maxdev}$ is denoted **590** and the intensity of the bbc at $\lambda_{maxdev}$ is denoted **592.** Therefore, using the calculation above, over the wavelength range from about 430 nm to about 520 nm, spectrum **A** has a maximum percentage intensity deviation $I_{maxdev}$ of 95%, that is at the maximum percentage intensity deviation the normalized intensity of spectrum A at wavelength $\lambda_{maxdev}$ is 195% of the normalized intensity of the bbc at the same wavelength. In contrast, spectrum **B** has a maximum percentage intensity deviation $I_{maxdev}$ of only 30% (corresponding to peak **582**), that is the normalized intensity of spectrum **A** at wavelength $\lambda_{maxdev}$ is 130% of the normalized intensity of the bbc at this wavelength.

Roll-off wavelength, $\lambda_{RO}$, is defined as the wavelength at which the normalized intensity (I) decreases from its maximum intensity (denoted $I_{max}$) in the orange to region of the spectrum to half its maximum intensity (denoted ½ $I_{max}$). As described above, the maximum intensity $I_{max}$ within this wavelength region of the spectrum corresponds to photoluminescence converted light and the maximum intensity occurs at a wavelength longer than about 570 nm. For instance, the maximum intensity may occur at wavelength ranging from about 590 nm to about 620 nm.

Packaged white light emitting device test method

The packaged test method involves measuring total light emission of a packaged white light emitting device (FIG. **3a**) in an integrating sphere.

Packaged full spectrum white light emitting devices in accordance with the invention (Dev.#) each comprise a 2835 (2.8mm x 3.5mm) SMD package containing three 1133 (11mil by 33mm) LED chips of dominant wavelength $\lambda_{d1}$ = 443 nm, $\lambda_{d2}$ = 451 nm and $\lambda_{d3}$ = 457 nm.

In this specification, the following nomenclature is used to denote white light emitting devices: Com.# denotes a comparative light emitting device in which each excitation source comprises one or more solid-state light sources of a single dominant wavelength and Dev.# denotes a white light emitting device in accordance with an embodiment of the invention in which each excitation source comprises solid-state light sources of at least two or at least three different dominant wavelengths.

2700K full spectrum white light emitting devices test data

**Tables 3, 4** and **5** tabulate measured optical test data for 2700K white light emitting devices Dev.1, Dev.2 and a known CRI90 comparative device Com.1 and illustrate the effect on efficacy of reducing the red spectral content while maintaining the blue and cyan spectral content.

Light emitting devices Dev.1 and Dev.2 each comprise a 2835 package containing three LED chips of dominant wavelength $\lambda_{d1}$ = 443 nm, $\lambda_{d2}$ = 451 nm and $\lambda_{d3}$ = 457 nm. Dev.1 comprises a combination of GAL520 and CASN650 phosphors and Dev.2 comprises a combination of GAL520, GAL530, CASN625 and CASN650 phosphors. The combination of CASN625 and CASN650 produces a peak emission of about 628 nm with the wavelength depending on the relative proportion of CASN625 to CASN650. Comparative device Com.1 comprises a known 2835 packaged white light emitting device which utilizes a narrowband excitation source and has a nominal CRI Ra of 90.

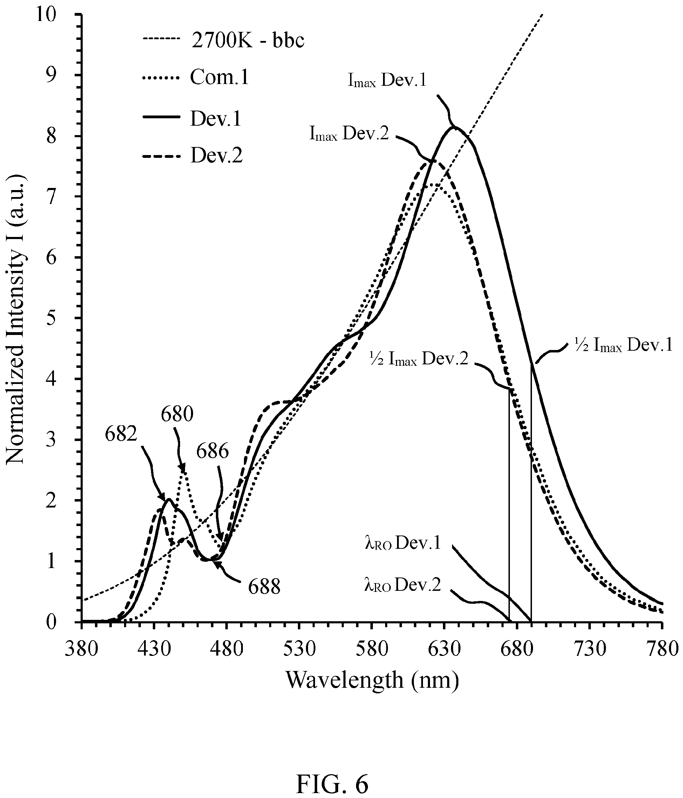

FIG. **6** are emission spectra, normalized intensity (normalized to a CIE 1931 XYZ relative luminance Y=100) versus wavelength (nm) for (i) Dev. 1 (solid line), (ii) Dev. 2 (thick dashed line), (iii) Com.1 (dotted line), and (iv) Planckian spectrum (thin dashed line) for a CCT of 2700K that is nominally the same as Dev. 1, Dev. 2, and Com.1. To make a meaningful comparison of the spectra, each spectrum has been normalized such each has a CIE 1931 XYZ relative luminance Y=100. The data are normalized using the CIE 1931 luminosity function $y(\lambda)$ of a standard observer which takes account of the photopic response of an observer. The Planckian spectrum (curve) or black-body curve in FIG. **6** represents the spectrum for a General CRI Ra equal to 100 for a given color temperature (CCT). Accordingly, for a white light emitting device of a given color temperature to have the highest color rendering possible, its emission spectrum should match as closely as possible the black-body spectrum of the same color temperature.

Referring to FIG. **6**, it will be noted that the effect on the emission spectral energy content of devices Dev.1 and Dev.2 in accordance with the invention (comprising a broadband excitation source) compared with the comparative device Com.1 (comprising a narrowband excitation source) are a significant reduction in the intensity of the blue emission peak **682** at about 430 nm and 440 nm respectively. As can be seen from the figure, the reduction of the blue emission peak **682** of devices Dev.1 and Dev.2 (compared with peak **680** of Com.1) results in the emission spectrum more closely resembling the Planckian spectrum (that is more closely resembling natural sunlight) over a wavelength range 430 nm to 520 nm (blue to cyan). More specifically, analysis of the spectra indicates that over a wavelength range 430 nm to 520 nm (blue to cyan), there is a maximum percentage normalized intensity deviation $I_{maxdev}$ of about 60% between the normalized intensity of light emitted by devices Dev.1 and Dev.2 and the normalized intensity of light of a black-body curve (bbc) of the same Correlated Color Temperature (2700K). That is Dev.1 and Dev.2 each generate light with an intensity that is 160% of the intensity of light of the bbc at the same wavelength. The maximum deviation in normalized intensity occurs at wavelengths $\lambda_{maxdev}$ at about 430 nm and about 440 nm respectively. This is to be contrasted with the known comparative device Com.1, that utilizes a narrowband excitation light source, which generates white light that exhibits a maximum percentage deviation $I_{maxdev}$ in normalized intensity of about 80% occurring at a wavelength $\lambda_{maxdev}$ of about 450 nm.

It will be appreciated that devices Dev.1 and Dev.2 thus produce white light that more closely resembles natural light over this wavelength region where human non-visual perception measured by CAF (Circadian Action Factor) are affected most and this can be beneficial to human wellbeing. It is believed that this change in spectral energy content resulting from the use of a broadband blue excitation source that at least partially fills the trough in the cyan region of the spectrum and reduces the peak overshoot in the blue region accounts for the superior color rendering properties of the devices of the invention. As can be seen from **Table 3,** devices Dev.1 and Dev.2 produce white light having a CAF that is within 1.9% and 0.8% respectively of that of natural light (bbc for a CCT 2700K). In comparison, comparative device Com. 1 has a CAF that is within 3.8% of that of natural light.

Turning to the intensity roll-off (tail) of the spectra in the orange to red region of the spectrum (i.e. for wavelength longer than about 570 nm). For Dev. 1, the maximum peak intensity ($I_{max}$ Dev. 1) is about 8.2 and this occurs at a wavelength of about 640 nm. The intensity (I) drops to half this value (½ $I_{max}$ Dev. 1) at a wavelength ($\lambda_{RO}$ Dev. 1) of about 690 nm.

For Dev.2 the maximum peak intensity ($I_{max}$ Dev.2) is about 7.6 and this occurs at a wavelength of about 620 nm. The intensity (I) drops to half this value (½ $I_{max}$ Dev.2) at a wavelength ($\lambda_{RO}$ Dev. 2) of about 675 nm.

**Table 3**

| | | | | | | | |
|---|---|---|---|---|---|---|---|
| 2700K white light emitting devices - Measured test data (bbc = black-body curve) | | | | | | | |
| Device | Efficacy (lm/W) | Efficacy (%) | Maximum deviation | | $\lambda_{RO}$ (nm) | CAF | CAF (%) |
| | | | $I_{maxdev}$ (%) | $\lambda_{maxdev}$ (nm) | | | |
| Com.1 | 123 | - | 80 | 450 | 675 | 0.354 | 96.2 |
| Dev.1 | 104 | 100 | 60 | 440 | 690 | 0.361 | 98.1 |
| Dev.2 | 119 | **115** | 60 | 435 | 675 | 0.371 | 100.8 |
| bbc | N/A | N/A | N/A | N/A | N/A | 0.368 | 100.0 |

**Table 4**

| | | | | | | | | | |
|---|---|---|---|---|---|---|---|---|---|
| 2700K white light emitting devices - Measured test data | | | | | | | | | |
| Device | CIE Color Rendering CRI | | | | | | | | |
| | R1 | R2 | R3 | R4 | R5 | R6 | R7 | R8 | R9 |
| Com.1 | 90.7 | 98.3 | 95.5 | 93.1 | 90.1 | 92.4 | 93.7 | 80.7 | 53.7 |
| Dev.1 | 97.7 | 99.0 | 93.7 | 93.7 | 97.3 | 99.4 | 96.8 | 97.2 | 98.2 |
| Dev.2 | 99.1 | 99.3 | 98.1 | 96.5 | 98.1 | 94.9 | 93.9 | **86.6** | **69.6** |

**Table 5**

2700K white light emitting devices - Measured test data

| Device | CIE Color Rendering CRI | | | | | | |
|---|---|---|---|---|---|---|---|
| | R10 | R11 | R12 | R13 | R14 | R15 | Ra |
| Com.1 | 84.2 | 94.0 | 79.7 | 91.0 | 96.7 | 85.9 | 91.2 |
| Dev.1 | 96.6 | 91.2 | 95.2 | 98.5 | 95.5 | 98.4 | 96.9 |
| Dev.2 | 98.1 | 91.0 | 89.5 | 99.3 | 98.9 | 93.1 | 95.8 |

Referring to **Tables 3, 4** and **5** it is to be noted that device Dev.1 has an efficacy of 104 lm/W and produces white light with a CRI Ra greater than or equal to 95 (96.9) with each of CRI R1 to CRI R15 being 90 or higher (91.2 to 99.0). In comparison, device Dev.2 has an efficacy of 119 lm/W and produces white light with a CRI Ra greater than or equal to 95 (95.8) in which CRI R1 to CRI R7 and CRI R10 to CRI R15 are about 90 or higher (89.5 to 99.3), while CRI R8 (corresponding to "Reddish Purple") is greater than 72 and less than 90 (86.6), while CRI R9 (corresponding to "Saturated Red") is greater than 50 and less than 90 (69.6). Further, it is to be noted that while the quality of light produced by Dev.2 is substantially the same as that of Dev.1, the efficacy increases substantially by about 15% (from 104 lm/W to 119 lm/W).

It will be appreciated from FIG. **6** and **Table 3** that the increase in efficacy of Dev.2 compared with Dev.1 is a direct result of the spectral roll-off of Dev.2 occurring at a shorter wavelength (675 nm) than that of Dev.1 (690 nm).

3000K full spectrum white light emitting devices test data

**Tables 6, 7** and **8** tabulate measured optical test data for 3000K white light emitting devices Dev.3 to Dev.5 and known 3000K CRI90 and CRI80 comparative devices Com.2 and Com.3 respectively and illustrate the effect on efficacy of reducing the red spectral content while maintaining the blue and cyan spectral content.

Light emitting devices Dev.3 to Dev.5 each comprise a 2835 package containing three LED chips of dominant wavelength $\lambda_{d1}$ = 443 nm, $\lambda_{d2}$ = 451 nm and $\lambda_{d1}$ = 457 nm. Dev.3 comprises a combination of GAL520 and CASN650 phosphors while devices Dev.4 and Dev.5 a combination of GAL520, GAL530, CASN625 and CASN650 phosphors in which Dev.5 comprises a greater relative portion of CASN625 to CASN650 than Dev.4 (the combination of CASN625 and CASN650 in Dev.4 produces a peak emission of about 625 nm and the combination in Dev.5 produces a peak emission of about 628 nm). Comparative device Com.2 comprises a known 2835 packaged white light emitting device which utilizes a narrowband excitation source and has a nominal CRI Ra of 90. Com.3 comprises a known 2835 packaged white light emitting device which utilizes a narrowband excitation source and has a nominal CRI Ra of 80.

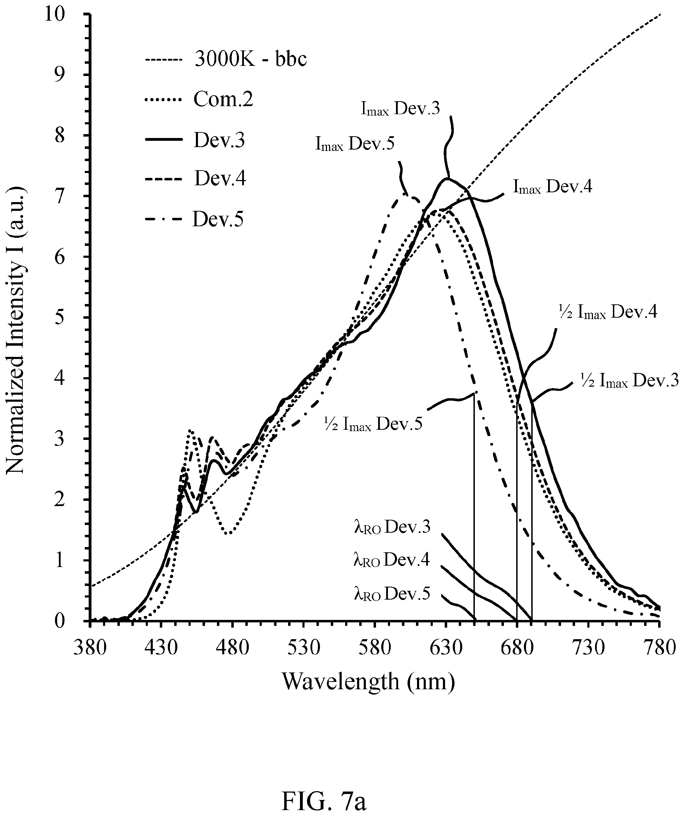

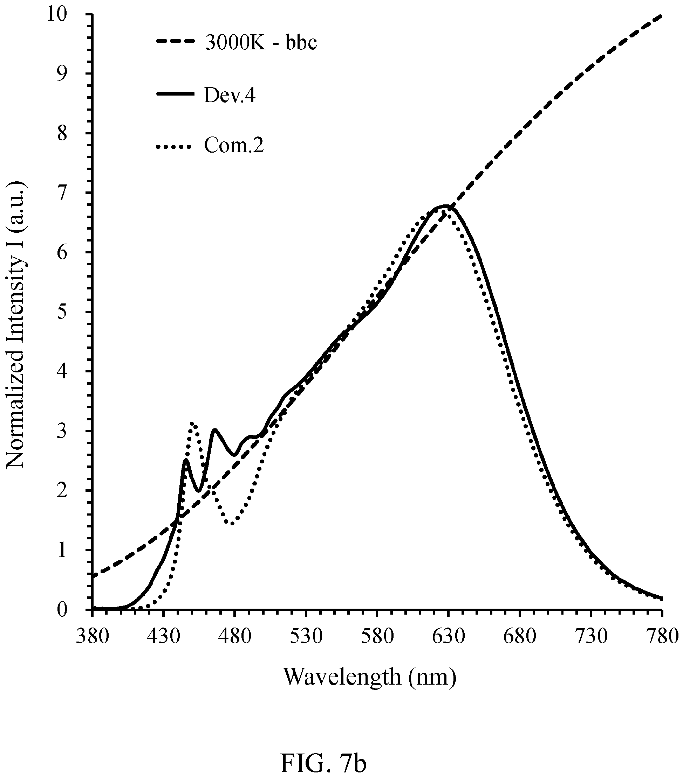

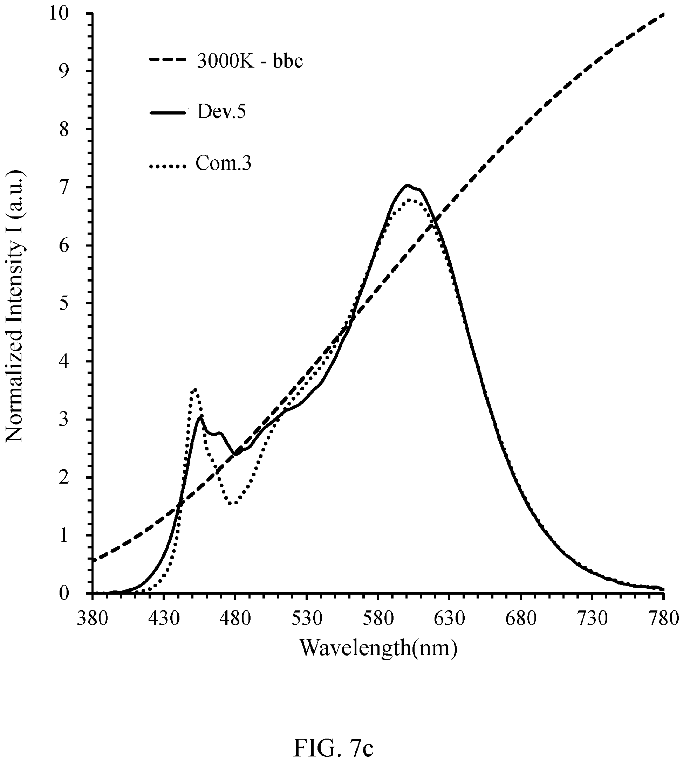

FIG. **7a** are emission spectra, normalized intensity (normalized to a CIE 1931 XYZ relative luminance Y=100) versus wavelength (nm) for (i) Dev. 3 (solid line), (ii) Dev. 4 (thick dashed line), (iii) Dev.5 (dash dot line), (iv) Com.2 (dotted line), and (v) Planckian spectrum or black-body curve (thin dashed line) for a CCT of 3000K that is nominally the same as Dev.3, Dev.4, Dev.5 and Com.2. FIG. **7b** are emission spectra, normalized intensity (normalized to a CIE 1931 XYZ relative luminance Y=100) versus wavelength (nm) for (i) Dev.4 (solid line), (ii) Com.2 (dotted line), and (iii) Planckian spectrum (dashed line) for a CCT of 3000K that is nominally the same as Dev.4 and Com.2. FIG. **7c** are emission spectra, normalized intensity (normalized to a CIE 1931 XYZ relative luminance Y=100) versus wavelength (nm) for (i) Dev.5 (solid line), (ii) Com.3 (dotted line), and (iii) Planckian spectrum (dashed line) for a CCT of 3000K that is nominally the same as Dev.5 and Com.3. Analysis of the spectrum indicates that over a wavelength range 430 nm to 520 nm (blue to cyan), a maximum percentage normalized intensity deviation $I_{maxdev}$ of about 40%, about 50% and about 60% between the normalized intensity of light emitted by devices Dev.3, Dev.4 and Dev.5 normalized intensity of light of a black-body curve of the same Correlated Color Temperature (3000K). This is to be contrasted with the known comparative devices Com.2 and Com.3, that utilizes a narrowband excitation light source, which generate white light that exhibits a maximum percentage deviation $I_{maxdev}$ in normalized intensity of about 70% and 100% respectively (at a wavelength of about 450 nm). Moreover, as can be seen from **Table 6** devices Dev.3, Dev.4 and Dev.5 produce white light having a CAF that is within 3.4%, 4.1% and 3.4% of that of natural light (bbc for a CCT 3000K). In comparison, comparative devices Com.2 and Com.3 have a CAF that is only within 11.5% and 9.5% respectively of that of natural light.

It will be appreciated that each of devices Dev.3, Dev.4 and Dev.5 thus produce white light that more closely resembles natural light over this wavelength region where human non-visual perception measured by CAF (Circadian Action Factor) or Melanopic Ratio (MR) are affected most and this can be beneficial to human wellbeing.

Turning to the intensity roll-off (tail) of the spectra in the orange to red region of the spectrum (i.e. for wavelength longer than about 570 nm). For Dev.3 the maximum peak intensity ($I_{max}$ Dev.3) is about 7.3 and this occurs at a wavelength of about 630 nm. The intensity (I) drops to half this value (½ $I_{max}$Dev.3) at a wavelength ($\lambda_{RO}$ Dev.3) of about 690 nm.

For Dev.4 the maximum peak intensity ($I_{max}$ Dev.4) is about 6.8 and this occurs at a wavelength of about 625 nm. The intensity (I) drops to half this value (½ $I_{max}$ Dev.4) at a wavelength ($\lambda_{RO}$ Dev.4) of about 680 nm.

For Dev.5 the maximum peak intensity ($I_{max}$ Dev.5) is about 7.0 and this occurs at a wavelength of about 605 nm. The intensity (I) drops to half this value (½ $I_{max}$ Dev.5) at a wavelength ($\lambda_{RO}$ Dev.5) of about 650 nm.

**Table 6**

3000K white light emitting devices - Measured test data (bbc = black-body curve)

| Device | Efficacy (lm/W) | Efficacy (%) | Maximum deviation | | $\lambda_{RO}$ (nm) | CAF | CAF (%) |
|---|---|---|---|---|---|---|---|
| | | | $I_{maxdev}$ (%) | $\lambda_{maxdev}$ (nm) | | | |
| Com.2 | 127 | - | 70 | 450 | 680 | 0.386 | 88.5 |
| Dev.3 | 109 | 100 | 40 | 445 | 690 | 0.451 | 103.4 |
| Dev.4 | **120** | 110 | 50 | 445 | 680 | 0.454 | 104.1 |
| Com.3 | 144 | - | 100 | 450 | 655 | 0.395 | 90.5 |
| Dev.5 | **149** | 137 | 60 | 455 | 650 | 0.451 | 103.4 |
| bbc | N/A | N/A | N/A | N/A | N/A | 0.436 | 100.0 |

**Table 7**

3000K white light emitting devices - Measured test data

| Device | CIE Color Rendering CRI | | | | | | | | |
|---|---|---|---|---|---|---|---|---|---|
| | R1 | R2 | R3 | R4 | R5 | R6 | R7 | R8 | R9 |
| Com.2 | 91.2 | 94.5 | 97.4 | 92.0 | 90.6 | 93.7 | 92.9 | 81.1 | 55.9 |
| Dev.3 | 98.2 | 97.9 | 92.2 | 93.1 | 97.4 | 97.6 | 95.1 | 95.3 | 96.2 |
| Dev.4 | 97.1 | 97.0 | 95.7 | 95.8 | 96.7 | 96.6 | 95.2 | 90.8 | **77.8** |
| Com.3 | 81.1 | 90.7 | 96.5 | 79.9 | 80.7 | 87.9 | 83.7 | 61.2 | 12.4 |
| Dev.5 | 84.2 | 94.5 | 93.0 | 83.6 | 85.5 | 95.1 | 82.2 | 60.0 | **11.9** |

**Table 8**

3000K white light emitting devices - Measured test data

| Device | CIE Color Rendering CRI | | | | | | |
|---|---|---|---|---|---|---|---|
| | R10 | R11 | R12 | R13 | R14 | R15 | Ra |
| Com.2 | 86.8 | 92.6 | 76.8 | 91.9 | 97.9 | 86.5 | 91.7 |
| Dev.3 | 94.2 | 91.8 | 93.3 | 99.3 | 94.9 | 98.0 | 95.9 |
| Dev.4 | 92.4 | 95.9 | 91.6 | 97.0 | 96.9 | 94.6 | 95.6 |
| Com.3 | 78.4 | 78.5 | 66.3 | 83.3 | 98.6 | 74.5 | 82.7 |
| Dev.5 | 88.7 | 84.9 | 85.6 | 87.0 | 96.5 | 75.4 | 85.0 |

Referring to **Tables 6, 7** and **8,** it is to be noted that device Dev.3 has an efficacy of 109 lm/W and produces white light with a CRI Ra greater than 95 (95.9) with each of CRI R1 to CRI R15 is 90 or higher (91.8 to 99.3). In comparison, device Dev.4 has a efficacy of 149 lm/W and produces white light with a CRI Ra greater than 95 (95.6) with each of CRI R1 to CRI R8 and CRI R10 to CRI R15 is 90 or higher while CRI R9 (corresponding to "Saturated Red") is greater than 50 and less than 90 (77.8). In comparison, device Dev.5 has an efficacy of 120 lm/W and produces white light with a CRI Ra greater than or equal to 85 (85.0) with each of CRI R1 to CRI R7 and CRI R10 to CRI R15 is 90 or higher, while CRI R8 (corresponding to "Reddish Purple") is less than 72 (60.0), while CRI R9 (corresponding to "Saturated Red") is greater than 10 and less than 90 (11.9). Further, it is to be noted that while the quality of light produced by Dev.4 and Dev.5 are substantially the same as that of Dev.3 the efficacy increases substantially by about 20% and 50% respectively.

4000K full spectrum white light emitting devices test data

**Tables 9, 10** and **11** tabulate measured optical test data for 4000K white light emitting devices Dev.6 and a known 4000K CRI90 comparative device Com.4. Light emitting device Dev.6 comprises a 2835 package containing three LED chips of dominant wavelength $\lambda_{d1}$ = 443 nm, $\lambda_{d2}$ = 451 nm and $\lambda_{d1}$ = 457 nm and comprises a combination of GAL520 and CASN650 phosphors. Comparative device Com.4 comprises a known 2835 packaged white light emitting device which utilizes a narrowband excitation source and has a nominal CRI Ra of 90.

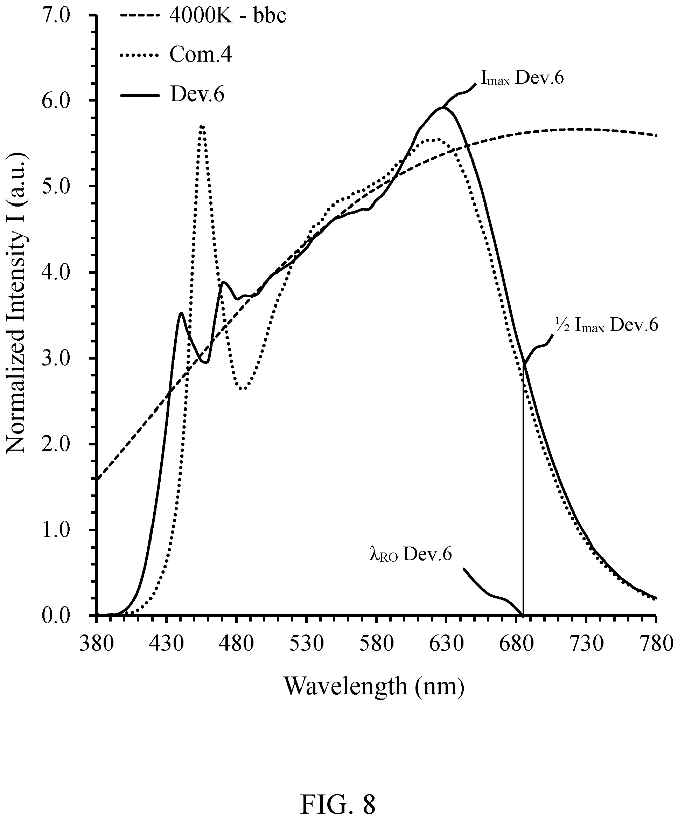

FIG. **8** are emission spectra, normalized intensity (normalized to a CIE 1931 XYZ relative luminance Y=100) versus wavelength (nm) for (i) Dev.6 (solid line), (ii) Com.4 (dotted line), and (v) Planckian spectrum (dashed line) for a CCT of 4000K that is nominally the same as Dev. 6 and Com.3. Analysis of the spectrum indicates that over a wavelength range 430 nm to 520 nm (blue to cyan), a maximum percentage normalized intensity deviation $I_{maxdev}$ of about 30%, that is the maximum difference between the normalized intensity of light emitted by devices Dev.6 normalized intensity of light of a black-body curve (bbc) of the same Correlated Color Temperature (4000K). This is to be contrasted with the known comparative device Com.2, that utilizes a narrowband excitation light source, which generate white light that exhibits a maximum percentage deviation $I_{maxdev}$ in normalized intensity of about 90% (at a wavelength of about 450 nm). Moreover, as can be seen from **Table 6** devices Dev.6 generates white light having a CAF that is 0.4% of that of natural light (bbc for a CCT 4000K). In comparison comparative device Com.3 has a CAF that is only within 7.0% of that of natural light.

It will be appreciated that device Dev.6 produces white light that more closely resembles natural light over this wavelength region where human non-visual perception measured by CAF (Circadian Action Factor) or Melanopic Ratio (MR) are affected most and this can be beneficial to human wellbeing.

Turning to the intensity roll-off (tail) of the spectra in the orange to red region of the spectrum (i.e. for wavelength longer than about 570 nm). For Dev.6 the maximum peak intensity ($I_{max}$ Dev.6) is about 5.9 and this occurs at a wavelength of about 630 nm. The intensity (I) drops to half this value (½ $I_{max}$Dev.6) at a wavelength ($\lambda_{RO}$ Dev.6) of about 685 nm.

| Table 9 | | | | | | |
|---|---|---|---|---|---|---|
| 4000K white light emitting device - Measured test data (bbc = black-body curve) | | | | | | |
| Device | Efficacy (lm/W) | Maximum deviation | | $\lambda_{RO}$ (nm) | CAF | CAF (%) |
| | | $I_{maxdev}$ (%) | $\lambda_{maxdev}$ (nm) | | | |
| Com.4 | 133 | 90 | 450 | 680 | 0.599 | 93.0 |
| Dev.6 | **117** | 30 | 440 | 685 | 0.646 | 99.6 |
| bbc | N/A | N/A | N/A | N/A | 0.644 | 100.0 |

| Table 10 | | | | | | | | | |
|---|---|---|---|---|---|---|---|---|---|
| 4000K white light emitting device - Measured test data | | | | | | | | | |
| Device | CIE Color Rendering CRI | | | | | | | | |
| | R1 | R2 | R3 | R4 | R5 | R6 | R7 | R8 | R9 |
| Com.4 | 95.0 | 96.9 | 96.8 | 92.5 | 92.7 | 93.9 | 95.4 | 91.1 | 79.2 |
| Dev.6 | 98.5 | 98.8 | 96.2 | 97.7 | 98.7 | 98.5 | 97.9 | 96.5 | **93.3** |

| Table 11 | | | | | | | |
|---|---|---|---|---|---|---|---|
| 4000K white light emitting device - Measured test data | | | | | | | |
| Device | CIE Color Rendering CRI | | | | | | |
| | R10 | R11 | R12 | R13 | R14 | R15 | Ra |
| Com.4 | 90.9 | 93.0 | 67.7 | 95.6 | 97.7 | 92.5 | 94.3 |
| Dev.6 | 97.3 | 97.3 | 94.9 | 98.4 | 97.3 | 97.7 | 97.8 |

Referring to **Tables 9, 10** and **11,** it is to be noted that device Dev.6 has an efficacy of 117 lm/W and produces white light with a CRI Ra greater than 95 (95.9) with each of CRI R1 to CRI R15 is 90 or higher (91.8 to 99.3).

*5000K full spectrum white light emitting devices test data*

Tables **12, 13** and **14** tabulate measured optical test data for 5000K white light emitting devices Dev.7 and Dev.8 and known 5000K CRI90 and CRI80 comparative devices Com.5 and Com.6 respectively and illustrate the effect on efficacy of reducing the red spectral content while maintaining the blue and cyan spectral content.

Light emitting devices Dev.7 and Dev.8 each comprise a 2835 package containing three LED chips of dominant wavelength $\lambda_{d1}$ = 443 nm, $\lambda_{d2}$ = 451 nm and $\lambda_{d1}$ = 457 nm. Dev.7 comprises a combination of GAL520 and CASN650 phosphors while devices Dev.8 a combination of GAL520, GAL530, CASN625 and CASN650 phosphors. Comparative device Com.5 comprises a known 2835 packaged white light emitting device which utilizes a narrowband excitation source and has a nominal CRI Ra of 90. Com.6 comprises a known 2835 packaged white light emitting device which utilizes a narrowband excitation source and has a nominal CRI Ra of 80.

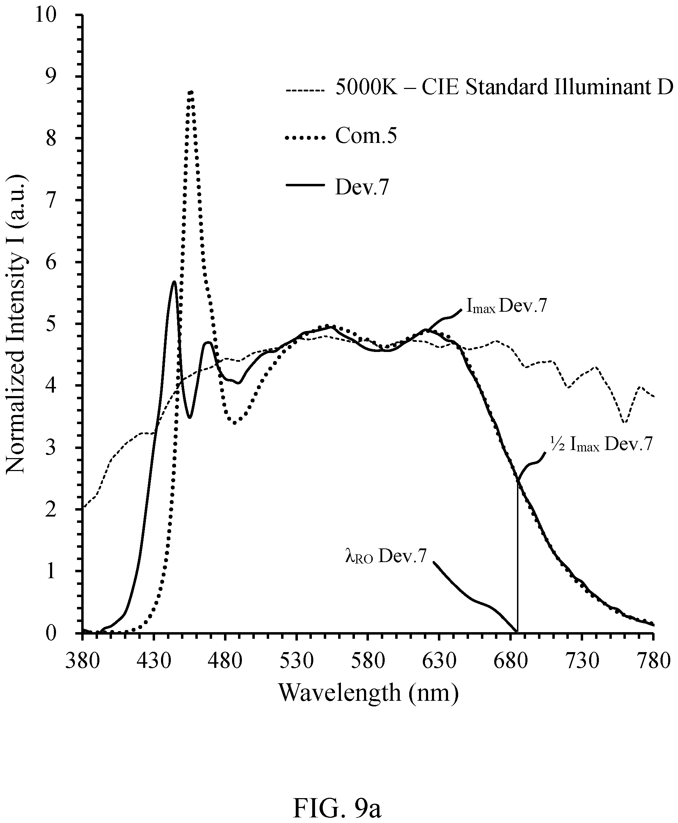

**FIG. 9a** are emission spectra, normalized intensity (normalized to a CIE 1931 XYZ relative luminance Y=100) versus wavelength (nm) for (i) Dev.7 (solid line), (ii) Com.5 (dotted line), and (iii) Planckian spectrum (dashed line) for a CCT of 5000K that is nominally the same as Dev.7 and Com.5. Analysis of the spectrum indicates that over a wavelength range 430 nm to 520 nm (blue to cyan), a maximum percentage normalized intensity deviation $I_{maxdev}$ of about 50% between the normalized intensity of light emitted by devices Dev.7 normalized intensity of light of the CIE Standard Illuminant D of the same Correlated Color Temperature (5000K). This is to be contrasted with the known comparative device Com.5, that utilizes a narrowband excitation light source, which generate white light that exhibits a maximum percentage deviation $I_{maxdev}$ in normalized intensity of about 115% (at a wavelength $\lambda_{maxdev}$ of about 450 nm). Moreover, As can be seen from **Table 12,** device Dev.7 produces white light having a CAF that is within 2.1% of that of natural light (CIE D for a CCT 5000K). In comparison, comparative device Com.5 has a CAF that is only within 12.6% of that of natural light.

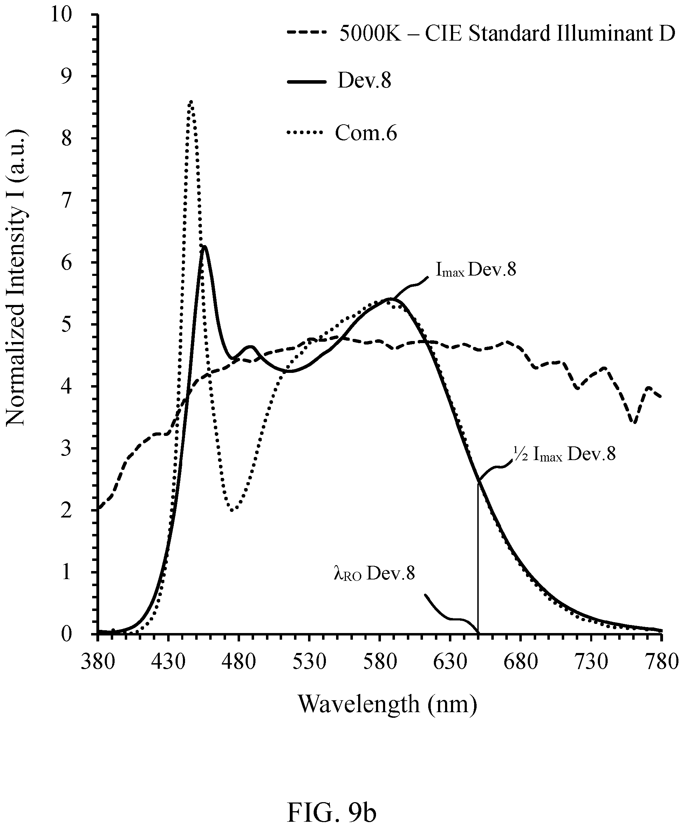

**FIG. 9b** are emission spectra, normalized intensity (normalized to a CIE 1931 XYZ relative luminance Y=100) versus wavelength (nm) for (i) Dev.8 (solid line), (ii) Com.6 (dotted line), and (iii) Planckian spectrum (dashed line) for a CCT of 5000K that is nominally the same as Dev.8 and Com.6. Analysis of the spectrum indicates that over a wavelength range 430 nm to 520 nm (blue to cyan), a maximum percentage normalized intensity deviation $I_{maxdev}$ of about 20% between the normalized intensity of light emitted by devices Dev.8 and the normalized intensity of light of the CIE Standard Illuminant D of the same Correlated Color Temperature (5000K). This is to be contrasted with the known comparative device Com.6, that utilizes a narrowband excitation light source, which generate white light that exhibits a maximum percentage normalized intensity deviation of about 140% (at a wavelength $\lambda_{maxdev}$ of about 450 nm). Moreover, as can be seen from **Table 12** device Dev.8 produces white light having a CAF that is within 2.0% of that of natural light (CIE D for a CCT 5000K). In comparison comparative device Com.6 has a CAF that is only within 13.1% of that of natural light.

It will be appreciated that each of devices Dev.7 and Dev.8 produce white light that more closely resembles natural light over this wavelength region where human non-visual perception measured by CAF (Circadian Action Factor) or Melanopic Ratio (MR) are affected most and this can be beneficial to human wellbeing.

Turning to the intensity roll-off (tail) of the spectra in the orange to red region of the spectrum (i.e. for wavelength longer than about 570 nm). For Dev.7 the maximum peak intensity ($I_{max}$ Dev.7) is about 4.9 and this occurs at a wavelength of about 625 nm. The intensity (I) drops to half this value (½ $I_{max}$ Dev.7) at a wavelength ($\lambda_{RO}$ Dev.7) of about 685 nm.

For Dev.8 the maximum peak intensity ($I_{max}$ Dev.8) is about 5.6 and this occurs at a wavelength of about 590 nm. The intensity (I) drops to half this value (½ $I_{max}$ Dev.8) at a wavelength ($\lambda_{RO}$ Dev.8) of about 650 nm.

| Table 12 | | | | | | | |
|---|---|---|---|---|---|---|---|
| 5000K white light emitting devices - Measured test data (bbc = black-body curve) | | | | | | | |
| Device | Efficacy (lm/W) | Efficacy (%) | Maximum deviation | | $\lambda_{RO}$ (nm) | CAP | CAP (%) |
| | | | $I_{maxdev}$ (%) | $\lambda_{max}$ (nm) | | | |
| Com.5 | 135 | - | 115 | 460 | 685 | 0.753 | 87.4 |
| Dev.7 | 117 | 100 | 50 | 445 | 685 | 0.824 | 102.1 |
| Com.6 | 165 | - | 140 | 445 | 645 | 0.701 | 86.9 |
| Dev.8 | 152 | **130** | 20 | 455 | 650 | 0.791 | 98.0 |
| bbc | N/A | N/A | N/A | N/A | N/A | 0.807 | 100.0 |

**Table 13**

5000K white light emitting devices - Measured test data

| Device | CIE Color Rendering CRI | | | | | | | | |
|---|---|---|---|---|---|---|---|---|---|
| | R1 | R2 | R3 | R4 | R5 | R6 | R7 | R8 | R9 |
| Com.5 | 96.0 | 99.1 | 98.3 | 88.8 | 92.4 | 95.7 | 91.4 | 90.5 | 87.1 |
| Dev.7 | 98.3 | 98.8 | 98.8 | 98.5 | 98.7 | 98.9 | 98.7 | **97.6** | **93.5** |
| Com.6 | 82.4 | 87.6 | 90.8 | 83.9 | 82.2 | 81.8 | 89.9 | 73.5 | 23.5 |
| Dev.8 | 82.4 | 93.5 | 93.4 | 81.1 | 83.9 | 90.6 | 83.9 | **62.6** | **1.3** |

**Table 14**

5000K white light emitting devices - Measured test data

| Device | CIE Color Rendering CRI | | | | | | |
|---|---|---|---|---|---|---|---|
| | R10 | R11 | R12 | R13 | R14 | R15 | Ra |
| Com.5 | 97.3 | 90.7 | 64.6 | 97.5 | 99.4 | 92.1 | 94.0 |
| Dev.7 | 98.6 | 99.0 | 96.4 | 98.0 | 98.8 | 97.3 | 98.5 |
| Com.6 | 70.0 | 82.4 | 56.0 | 83.5 | 95.0 | 78.2 | 84.0 |
| Dev.8 | 85.2 | 81.2 | 73.1 | 85.9 | 96.4 | 75.0 | 83.9 |

Referring to **Tables 12, 13** and **14** it is to be noted that device Dev.7 has an efficacy of 117 lm/W and produces white light with a CRI Ra greater than 95 (98.5) in which each of CRI R1 to CRI R15 is 90 or higher (93.5 to 99.0). In comparison, device Dev.8 has an efficacy of 152 lm/W and produces white light with a CRI Ra greater than 80 (83.9), while CRI R8 (corresponding to "Reddish Purple") is less than 72 (62.6), while CRI R9 (corresponding to "Saturated Red") is greater than zero and less than 90 (1.3). Further, it is to be noted that while the quality of light produced by Dev.8 is substantially the same as that of Dev.7 the efficacy increases substantially by about 30% and is comparable with Com.6.

As described above, a particular advantage of the present invention is that full spectrum white light emitting devices according to embodiments of the invention can generate full spectrum light that closely resembles natural light in blue to cyan (430 nm to 520 nm) region where human non-visual perception measured by CAF (Circadian Action Factor) or Melanopic Ratio (MR) are affected most. There has been much discussion in the lighting industry regarding blue light stimulation and its impact on circadian rhythm. The amount of blue to cyan light in a light source impacts melatonin secretion which can impact the circadian cycle. High levels of blue to cyan light suppress melatonin secretion, energizing the human body. Low levels of blue light do not suppress melatonin secretion, relaxing the human body. One metric used to estimate this non-visual effect is the CAF Circadian Action Factor, which typically is modulated by blue content throughout the day. At noon time the sun has a high CCT and higher blue to cyan content. Sunrise and sunset have a lower CCT and lower blue to cyan content. CAF value of natural light at a different CCT is a good measure of the lighting deviation from the nature light in blue to cyan region where human emotional, health, or wellbeing life are affected.

CSP (Chip Scale Packaged) full spectrum white light emitting devices

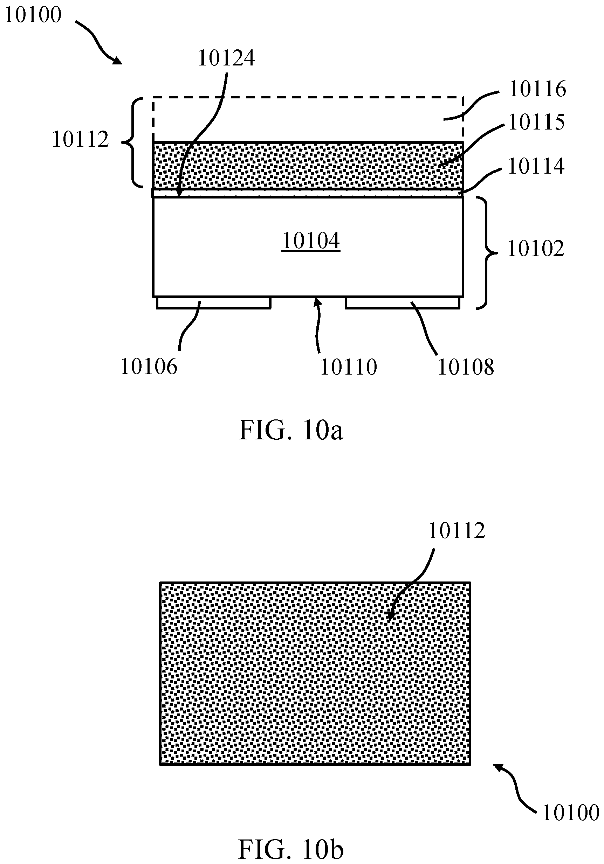

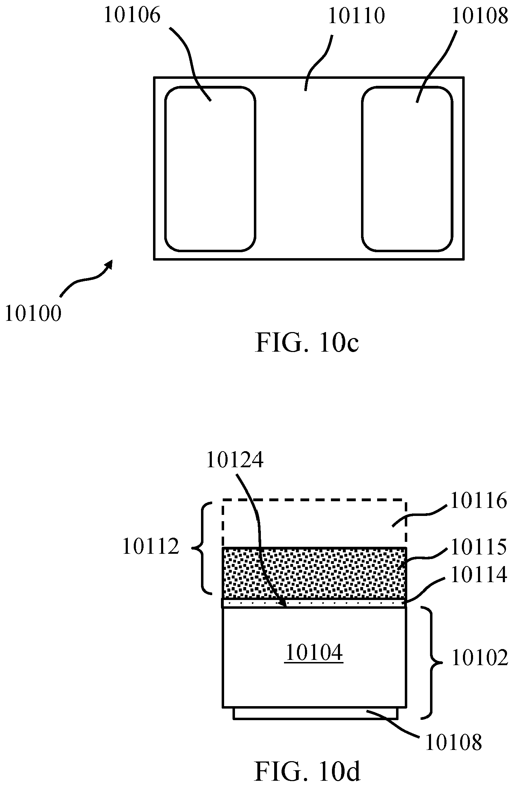

A CSP full spectrum white light emitting device according to an embodiment of the invention will now be described with reference to **FIGS. 10a** to **10d** that show schematic representations of a CSP device **10100** in which: **FIG. 10a** shows a side view, **FIG. 10b** shows a top view, **FIG. 10c** shows a bottom view, and **FIG. 10d** shows an end view. The device **10100** comprises a broadband blue LED flip chip **10102** that comprises an LED chip (die) **10104** having anode and cathode contact pads **10106, 10108** on its bottom (lower as shown) face **10110**. The LED chip (die) **10104** has a top light emitting face (upper as shown) face **10124**. The LED flip chip **10102** may comprise a GaN, InGaN or InGaN/GaN MQW (Multiple Quantum Well) LED chip (die) that generates broadband violet to blue light with a dominant wavelength from about 380 nm to about 495 nm with a FWHM (Full Width at Half Maximum) of at least 25 nm, typically 25 nm to 50 nm. In a MQW LED, multiple quantum wells in the active region generate multiple narrowband (FWHM < 20 nm) emissions that combined produce a broadband emission.

The device **10100** further comprises a photoluminescence wavelength conversion component **10112,** in the form of a layer (film), that covers the top (upper as shown) light emitting face **10124** of the LED chip (die) **10104.** The photoluminescence wavelength conversion component **10112** comprises at least one photoluminescence layer, which, in this embodiment, is a single photoluminescence layer **10115.** It will be appreciated that, in other embodiments, more than one layer may be present. The photoluminescence wavelength conversion component **10112** absorbs a portion of the blue excitation light generated by the LED chip **10102** and converts it to light of a different wavelength by a process of photoluminescence. The emission product of the device **10100,** which is white in color, comprises the combination of unconverted violet to blue light generated by the broadband blue LED chip **10102** and photoluminescence light generated by the photoluminescence wavelength conversion component **10112.** The photoluminescence wavelength conversion component **10112** may comprise a combination of green to red emitting photoluminescence materials as part of the photoluminescence layer **10115.**

The photoluminescence wavelength conversion component **10112** may comprise a layer of uniform thickness comprising a light transmissive material (for example, polycarbonate, acrylic material, silicone material, etc.) that incorporates a mixture of green to red emitting photoluminescence materials. As indicated in **FIG. 10a,** in this embodiment, a light transmissive material layer **10114** is optionally provided between the at least one photoluminescence layer and the top light emitting face **10124** of the LED chip (die) **10104.** In embodiments, it will be appreciated that the photoluminescence wavelength conversion component **10112** can be bonded to the top light emitting face **10124** of the LED die **10104** by a light transmissive material layer **10114.** Optionally, as shown in **FIG. 10a,** the photoluminescence wavelength conversion component **10112** may comprise a light transmissive layer **10116** (indicated by a dashed line), such as a light transmissive glass substrate or light transmissive polymer film layer, that covers the top face of the photoluminescence wavelength conversion component **10112.** A benefit of the light transmissive layer/substrate **10116** is that it can provide environmental protection to the photoluminescence materials within the photoluminescence wavelength conversion component **10112.** Since the photoluminescence wavelength conversion component **10112** may be thin, a few tens to a few hundred of micrometers in thickness, the light transmissive layer/substrate **10116** can ease manufacture of the wavelength conversion component by depositing it directly on the light transmissive layer/substrate **10116.**

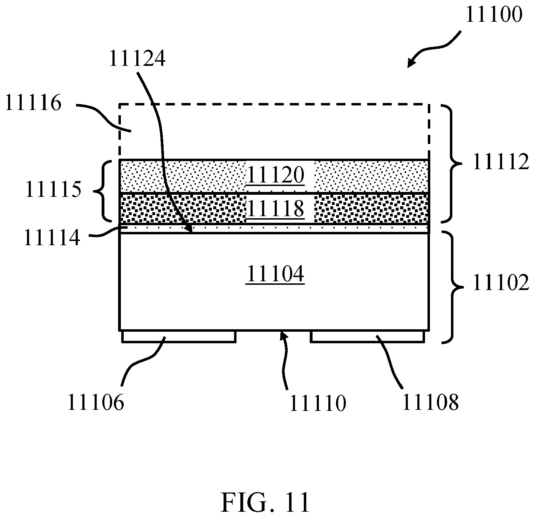

**FIG. 11** is a side view of a CSP full spectrum white light emitting device **11100** in accordance with an embodiment of the invention. This embodiment is essentially the same as that of **FIGS. 10a** to **10d,** except that the photoluminescence wavelength conversion component **11112** comprises a double-layer structure (double photoluminescence layer **11115**) comprising respective first and second photoluminescence layers **11118, 11120** that comprise different photoluminescence materials. A double-layer structure can be beneficial when the photoluminescence materials have differing excitation characteristics. For example, narrowband red phosphors such as $K_2SiF_6$:Mn, $K_2TiF_6$:Mn, or $K_2GeF_6$:Mn are much less excitable than YAG or CASN and can be located in the first photoluminescence layer **11118** that is proximal to the LED die **11104** while the other photoluminescence materials can be located in the second photoluminescence layer **11120** (distal to the LED die **11104** ). Such an arrangement can reduce the quantity of narrowband red phosphor required to generate light of a selected color temperature, thus reducing costs, and improving the cost efficiency to manufacture the device.

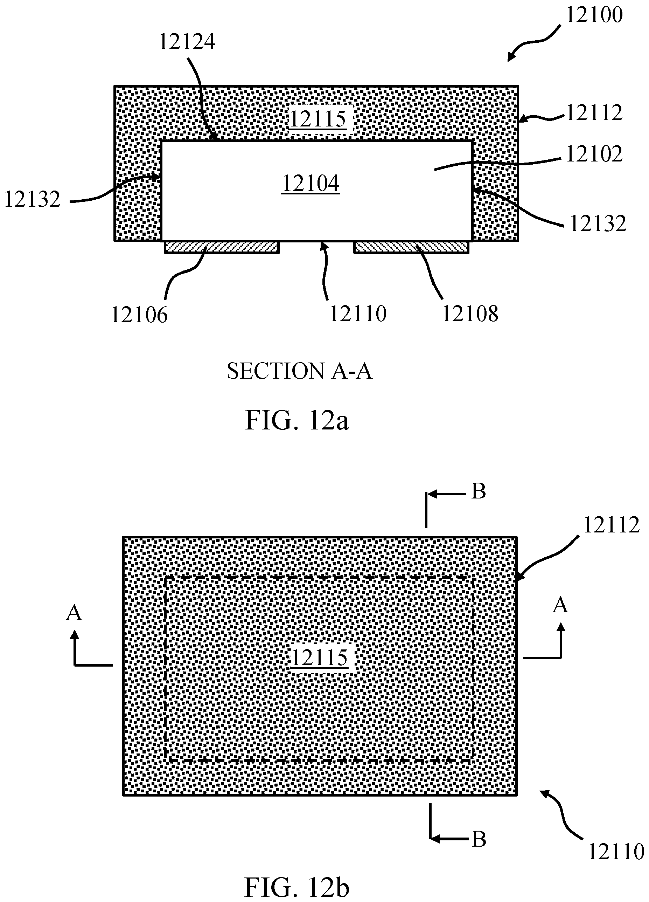

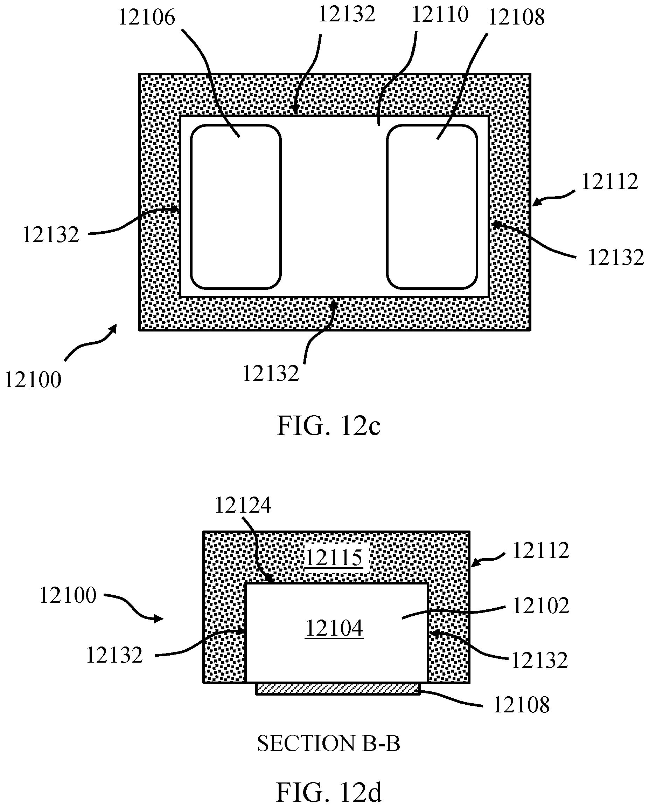

**FIGS. 12a** to **12d** are schematic representations of a CSP full spectrum white light emitting device **12100** according to an embodiment of the invention in which: **FIG. 12a** shows a sectional side view through A-A, **FIG. 12b** shows a top view, **FIG. 12c** shows a bottom view, and **FIG. 12d** shows a sectional end view through B-B. This embodiment is essentially the same as that of **FIGS. 10a** to **10d,** except that the photoluminescence wavelength conversion component **12112,** which is in the form of a single-layer structure (photoluminescence layer **12115**), covers not only the light emitting top face (upper as shown) **12124** of the LED die **12104,** but also covers each of the four side faces **12132** of the LED die **12104.** The photoluminescence wavelength conversion component **12112** can be in the form of a conformal coating of substantially uniform thickness. As shown, the thickness of the photoluminescence wavelength conversion component **12112** can be thicker on the top face **12124** of the LED die **12104** than on the side faces **12132** of the LED die **12104.** In this embodiment, for instance, the at least one photoluminescence layer (photoluminescence layer **12115**) is in direct contact with the light emitting top face **12124** of the LED die **12104.**

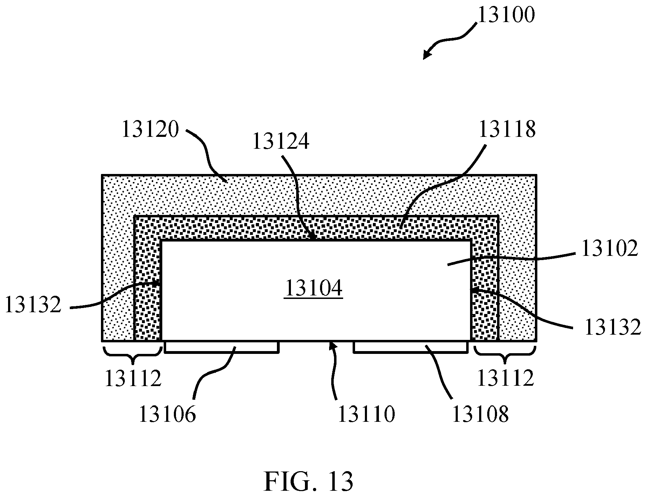

**FIG. 13** is a sectional side view of a CSP full spectrum white light emitting device **13100** in accordance with an embodiment of the invention. This embodiment is essentially the same as that of **FIGS. 12a** to **12d,** except that the photoluminescence wavelength conversion component **13112** that covers the top face **13124** and four side faces **13132** of the LED die **13104** comprises a double-layer structure (double photoluminescence layer **13115**) comprising respective first and second photoluminescence layers **13118, 13120** that comprise different photoluminescence materials. As shown, the first and second photoluminescence layers **13118, 13120** can be in the form of a conformal coating of substantially uniform thickness. The first and second photoluminescence layers **13118, 13120** may contain different photoluminescence materials such as those described in relation to **FIG. 11,** for example.

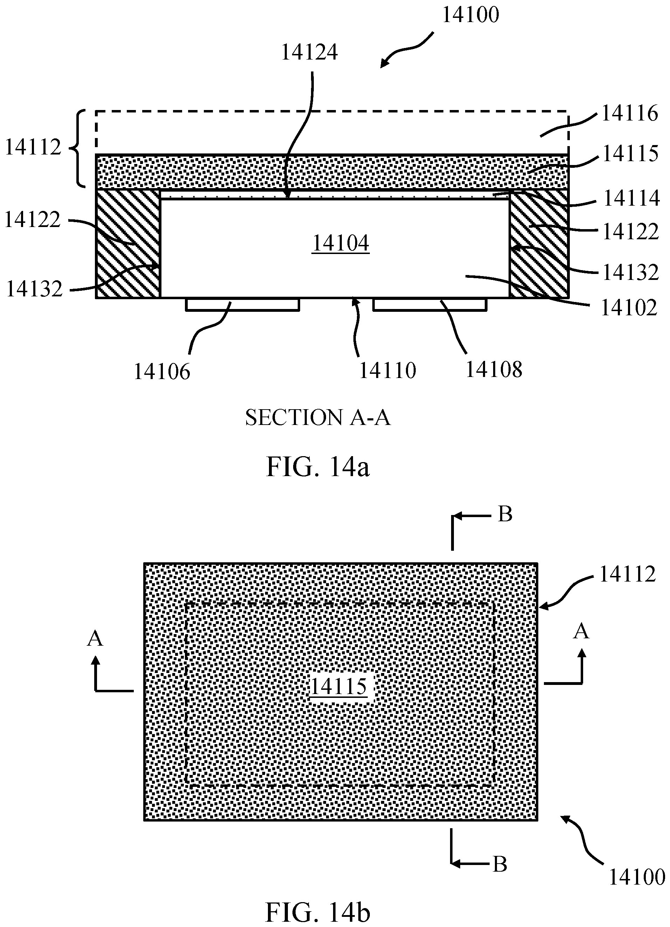

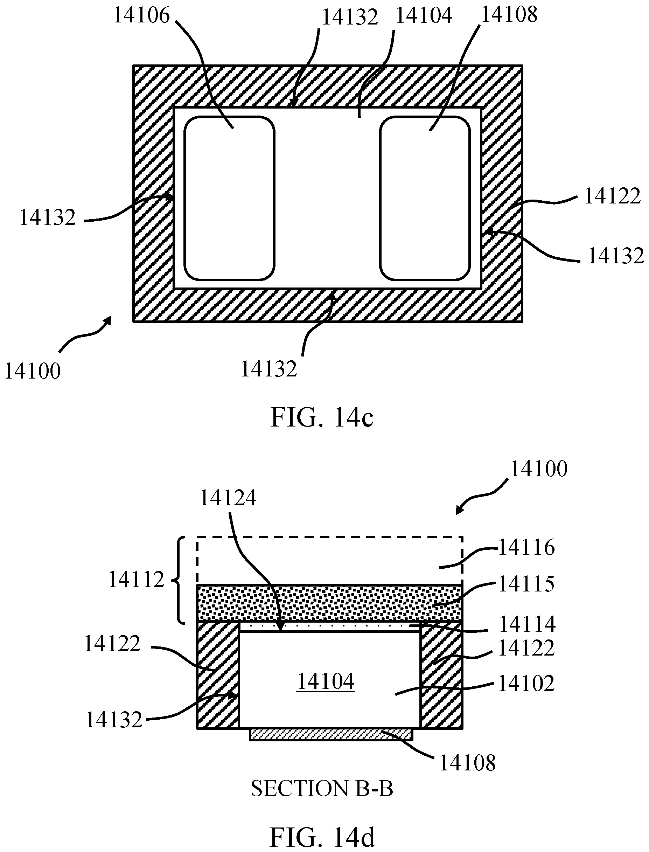

**FIGS. 14a** to **14d** are schematic representations of a CSP full spectrum white light emitting device **14100** according to an embodiment of the invention in which: **FIG. 14a** shows a sectional side view through A-A, **FIG. 14b** shows a top view, **FIG. 14c** shows a bottom view, and **FIG. 14d** shows a sectional end view through B-B. In this embodiment, the photoluminescence wavelength conversion component **14112** comprises a single-layer structure (film) (photoluminescence layer **14115**) that is applied (deposited) directly onto the light emitting top face (upper face as shown) **14124** of the LED flip chip **14102**. Optionally, as indicated in **FIG. 14a** the photoluminescence wavelength conversion component **14112** may comprise a light transmissive substrate **14116** (indicated by a dashed line) such as a glass substrate or light transmissive polymer film.

The device **14100** further comprises a light reflective material **14122** that covers the four light emitting side faces **14132** of the LED flip chip **14102** and constitutes a light reflective enclosure (cup) around the periphery of the LED die **14104** (**FIG 14c**). The light reflective material **14122** reflects light that would otherwise be emitted from the side faces **14132** of the LED chip back into the LED die **14104** and this light is subsequently emitted from the top light emitting face **14124** of the LED die (chip). In this embodiment, the white light emitting device **14100** comprises a light transmissive material layer **14114** between the at least one photoluminescence layer **14115** and the light emitting top face **14124** of the LED flip chip of the LED die **14104**. The light transmissive material layer **14114** is enclosed by the light reflective material **14122** and the at least one photoluminescence layer **14115** (photoluminescence wavelength conversion component **14112**). As can be seen from **FIG. 14a**, the photoluminescence wavelength conversion component **14112** may completely cover the top flush surfaces of the light transmissive material layer **14114** (and, consequently, the LED die **14104**) and the light reflective material **14122** thereby ensuring that all light generated by the device **14100** passes through, and is emitted from, photoluminescence layer **14115** of the photoluminescence wavelength conversion component **14112**. A benefit of such an arrangement is that this can increase the emission intensity of light generated by the device by confining the emission direction. A further benefit of the presence of the light reflective material **14122** is that this may lead to a more uniform color and uniform color over angle of emitted light.

The light reflective material **14122** can comprise a white material such as a white silicone material or like.

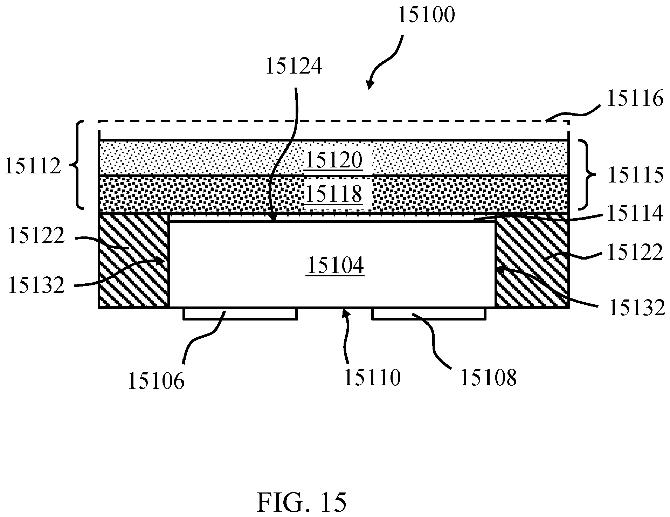

**FIG. 15** is a sectional side view of a CSP full spectrum white light emitting device **15100** in accordance with an embodiment of the invention. The device **15100** of **FIG. 15** is the same as that of **FIG. 14a** to **14d,** except that photoluminescence wavelength conversion component **15112** is a double-layer structure (double photoluminescence layer **15115**) comprising first and second photoluminescence layers **15118, 15120**. Optionally, as indicated in **FIG. 15,** the photoluminescence wavelength conversion component **15112** can comprise a light transmissive substrate **15116** (indicated by a dashed line) such as a glass substrate or light transmissive polymer film.

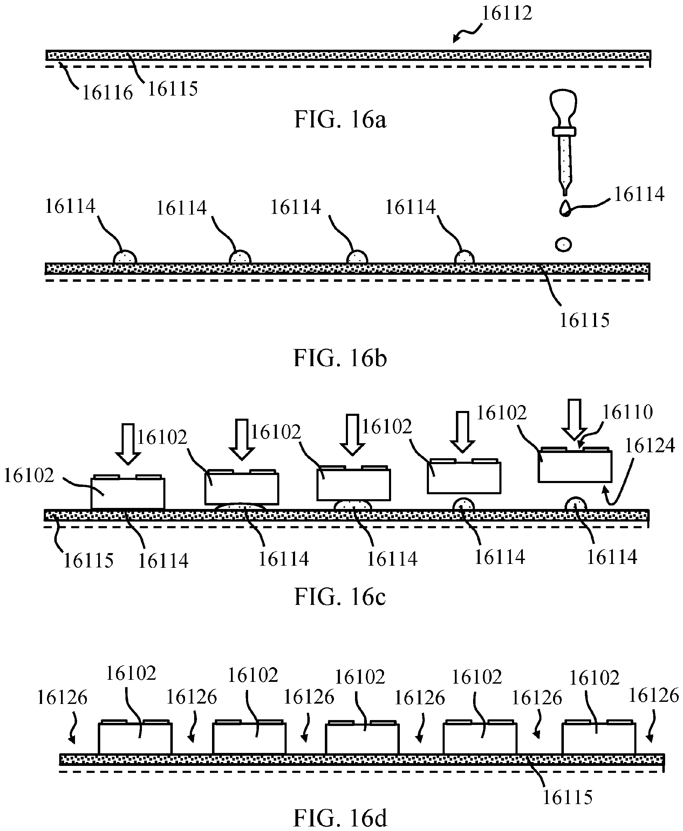

**FIGS. 16a** to **16g** illustrate a method of manufacture of devices such as those of **FIGS. 14a** to **14d.**

First, as shown in **FIG. 16a,** a single-layer photoluminescence wavelength conversion film **16112** is provided. The photoluminescence wavelength conversion film **16112** can be manufactured by, for example, extrusion, slot die coating or screen printing. For ease of fabrication and/or to provide environmental protection, a photoluminescence layer **16115** may be provided on a light transmissive layer/substrate **16116** such as a glass substrate or light transmissive polymer film, thereby constituting the photoluminescence wavelength conversion film **16112.**

Next, a measured quantity of a light transmissive material **16114,** such as, for example, a curable silicone optical encapsulant, is dispensed on the photoluminescence wavelength conversion film **16112** at predetermined locations (**FIG. 16b**). To maximize device yield from the photoluminescence film **16112,** the locations may, as illustrated, comprise a square array of rows and columns.

An LED flip chip **16102,** with its light emitting top face **16124** facing the photoluminescence film **16112** (i.e. base face of LED chip **16110** uppermost), is placed on a respective optical encapsulant **16114** and pushed into the optical encapsulant **16114** (The progressive stages of the LED flip chip **16102** being pushed into the optical encapsulant **16114** is shown in **FIG. 16c**). When cured, the encapsulant **16114** bonds the LED flip chip **16102** to the photoluminescence film **16112** and constitutes a thin light transmissive bonding layer, optical coupling layer **16114** (**14114** - **FIG. 14a**), between the photoluminescence film **16112** and the top light emitting face **16124** of the LED flip chip **16102.**

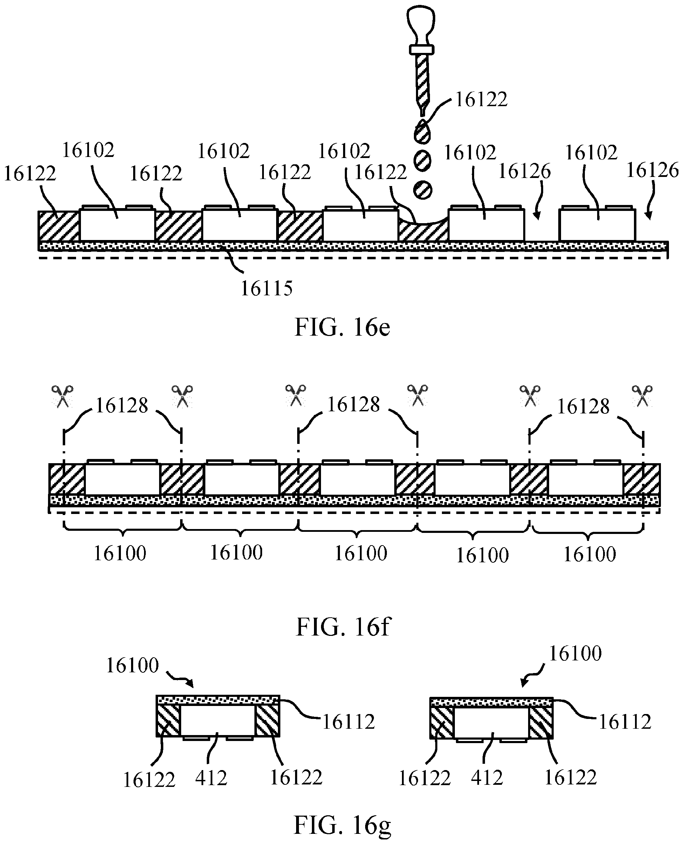

As indicated in **FIG. 16d,** there is a square lattice of valleys **16126** between rows and columns of LED flip chips **16102**. The valleys **16126** are filled with a light reflective material **16122,** such as, for example, a white silicone material (**FIG. 16e**).

Finally, as shown in **FIG. 16f,** individual devices **16100** are produced by cutting along cut lines **16128**. The cut individual devices **16100** can be seen in **FIG. 16g.**

It will be appreciated that a similar method can be used to manufacture the double-layer photoluminescence device **15100** of **FIG. 15** using a double-layer photoluminescence film **15112** comprising first and second photoluminescence layers.

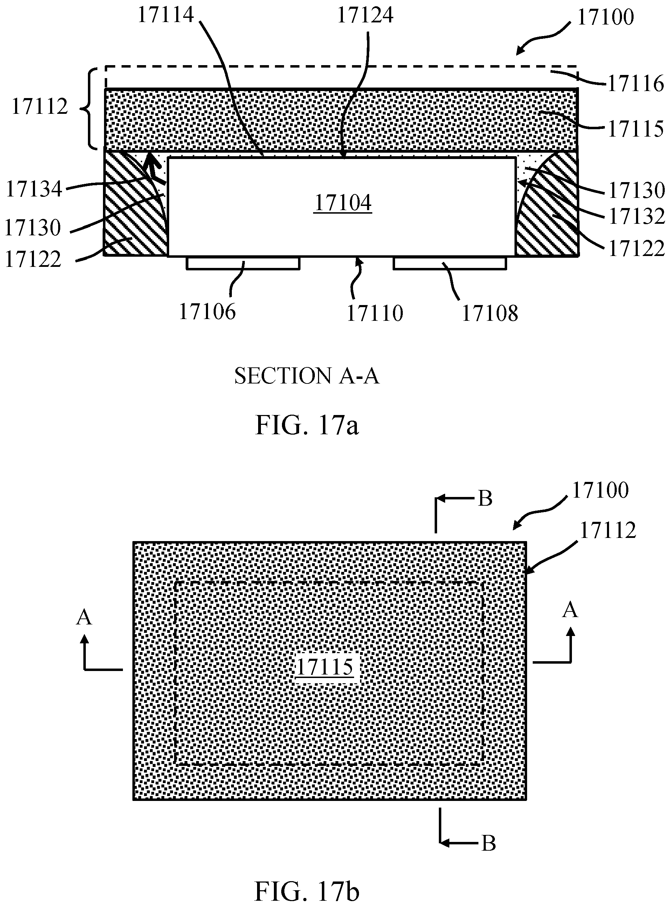

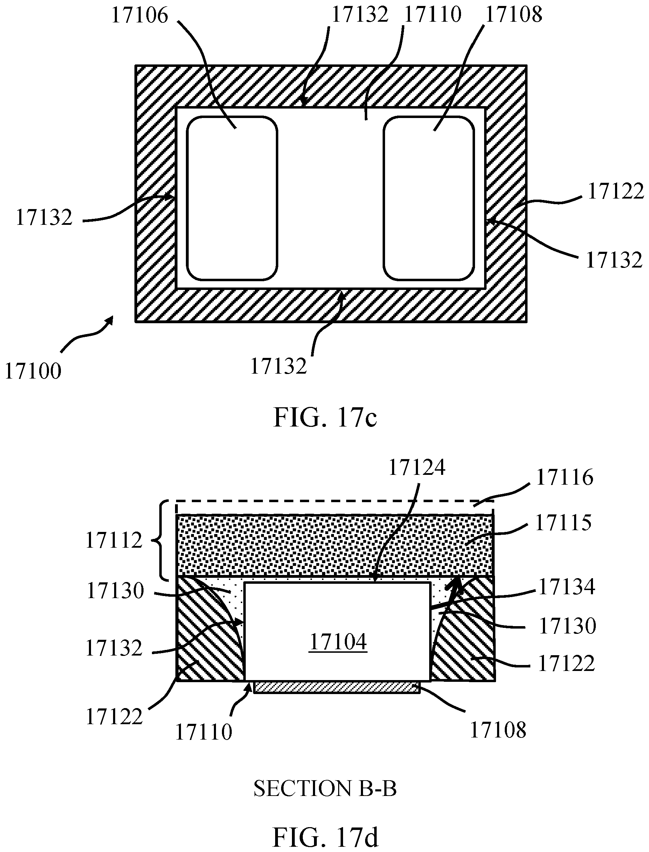

**FIGS. 17a** to **17d** are schematic representations of a CSP full spectrum white light emitting devices **17100** according to an embodiment of the invention in which: **FIG. 17a** shows a sectional side view through A-A, **FIG. 17b** shows a top view, **FIG. 17c** shows a bottom view, and **FIG. 17d** shows a sectional end view through B-B. The device **17100** of **FIGS. 17a** to **17d** is similar to that of **FIG. 14a** to **14d** and further comprises a light transmissive (material) region **17130** disposed between the four side faces **17132** of the LED chip **17104** and the light reflective material **17122**. The light transmissive (material) region **17130** is enclosed by the light reflective material **17122** and the at least one photoluminescence layer (in this embodiment, a single photoluminescence layer **16115**). As shown, the light transmissive (material) region **17130** reduces in thickness in a direction from the top face **17124** of the LED chip **17104** to the bottom face **17110** of the LED chip **17104.** In this embodiment, the light transmissive (material) region **17130** is arcuate in form. In other embodiments, the light transmissive (material) region may reduce in thickness through a different configuration. It is to be noted that the photoluminescence film (layer) **17115** extends laterally (left to right as shown) beyond the light emitting top face **17124** of the LED chip **17104** and covers at least the light transmissive (material) region **17130** and may, as indicated in the **FIGS. 17a** and **17d,** additionally cover at least the periphery of the light reflective region **17122.** The light transmissive (material) region **17130** may comprise a light transmissive silicone and the light reflective region **17122** can comprise a white material such as a white silicone material.

As can be seen from FIGS. **17a** and **17d,** the light transmissive portion (layer)/material/region **17130** is applied to each of the four light emitting side faces **17132** of the LED chip **17104** and has a form which extends upwardly and outwardly (laterally) in a curved fashion from the bottom face (base) **17110** of the LED chip **17104.** The light transmissive portion **17130** defines a light transmissive region around the periphery of the LED chip and allows light indicated by arrow **17134** emitted from the sides faces **17132** of the LED chip **17104** to travel to the photoluminescence layer **17115.** As described, the device **17100** further comprises a light reflective material **17122** in contact with the light transmissive region **17130** and has a form that extends upwardly and inwardly from the bottom face (base) **17110** of the LED chip **17104** and defines a light reflective enclosure (cup) around the periphery of the light transmissive portion **17130.** The light reflective portion **17122** reflects light indicated by arrow **17134** emitted from the side faces **17132** of the LED die **17104** in an upward direction towards the photoluminescence layer **17115.** As can be seen from **FIGS. 17a** and **17d,** the photoluminescence layer **17115** completely covers the top face **17124** of the LED die **17104,** light transmissive portion **17130,** and light reflective portion **17122** thereby maximizing light indicated by arrow **17134** emitted by the side faces **17132** of the LED die **17104** to be emitted through the photoluminescence layer **17122.** The light transmissive region **17130** in conjunction with the light reflective material **17122** increases light **17134** (heavy arrow - **FIG. 17a**) emitted by the side faces **17132** of the LED chip **17104** passing into the photoluminescence layer **17115.** The combination of a light transmissive portion (layer) **17130** covering the side faces **17132** of the LED die **17104** with a light reflective material **17122** covering the light transmissive portion **17122** can increase the emission intensity of light generated by the device.

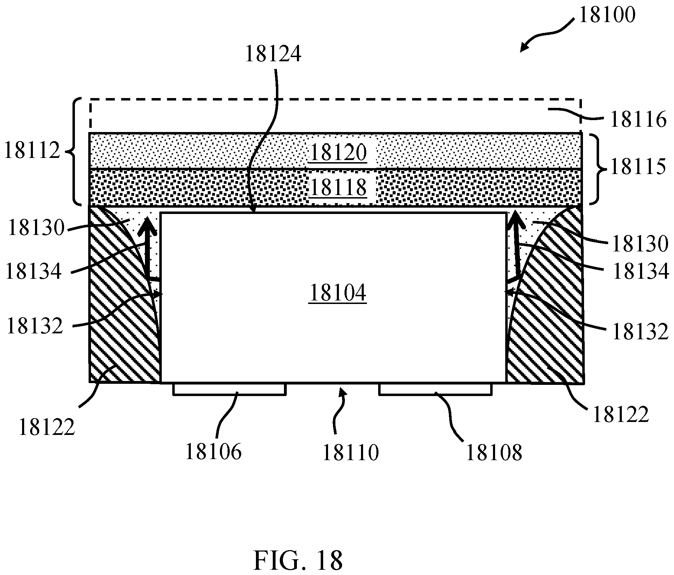

**FIG. 18** is a sectional side view of a CSP full spectrum white light emitting device 18100 in accordance with an embodiment of the invention. This embodiment is essentially the same as that of **FIGS. 17a** to **17d** except that the photoluminescence wavelength conversion component **18112** comprises a double-layer structure (double photoluminescence layer **18115**) comprising respective first and second photoluminescence layers **18118, 18120** that comprise different photoluminescence materials.

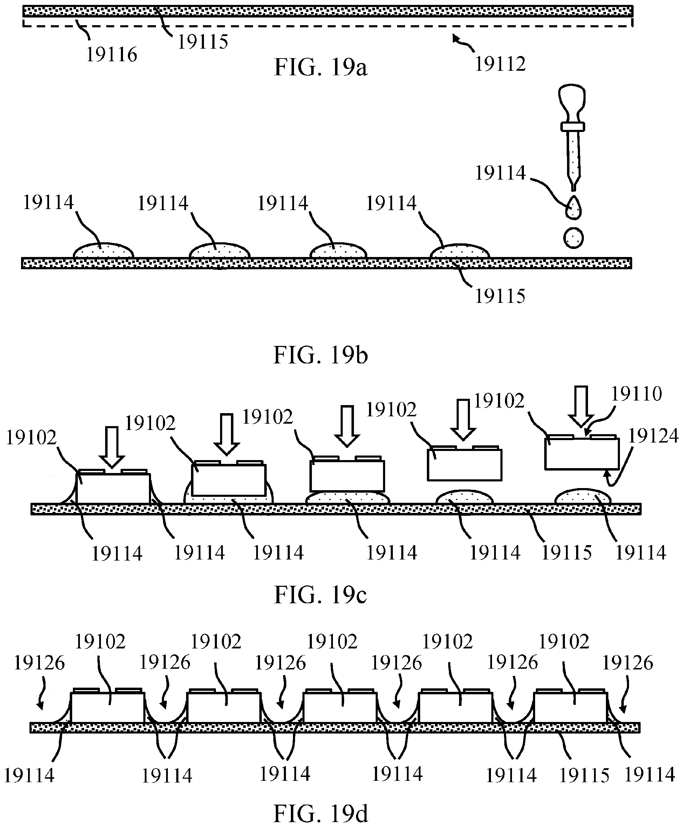

**FIGS. 19a** to **19g** illustrate a method of manufacture of a device such as device **17100** of **FIGS. 17a** to **17d.**

First, as shown in **FIG. 19a,** a photoluminescence layer (film) **19115** is provided. The photoluminescence film **19115** can be manufactured by for example extrusion, slot die coating or screen printing. As described herein, the photoluminescence film **19115** may optionally be provided on a light transmissive substrate **19116** (indicated by a dashed line) such as a glass substrate or light transmissive polymer film.

Next, with the photoluminescence layer **19115** oriented uppermost, a measured quantity of a light transmissive material **19114,** such as a curable silicone optical encapsulant, is dispensed on the photoluminescence layer **19115** at predetermined locations (**FIG. 19b**). To maximize device yield from the photoluminescence film **19115,** the locations may, as illustrated, comprise a square array of rows and columns.

An LED flip chip **19102,** with its light emitting top face **19124** facing the photoluminescence film **19115** (i.e., base **19110** uppermost), is placed on a respective optical encapsulant **19114** and pushed into the optical encapsulant **19114** (The progressive stages of the LED flip chip **19102** being pushed into the optical encapsulant **19114** is shown in **FIG. 19c**). The encapsulant **19114** forms a concave meniscus that extends upwardly and at least partially covers each of the four light emitting side faces **19132** of the LED dies **19104** as shown in **FIG. 19d.**

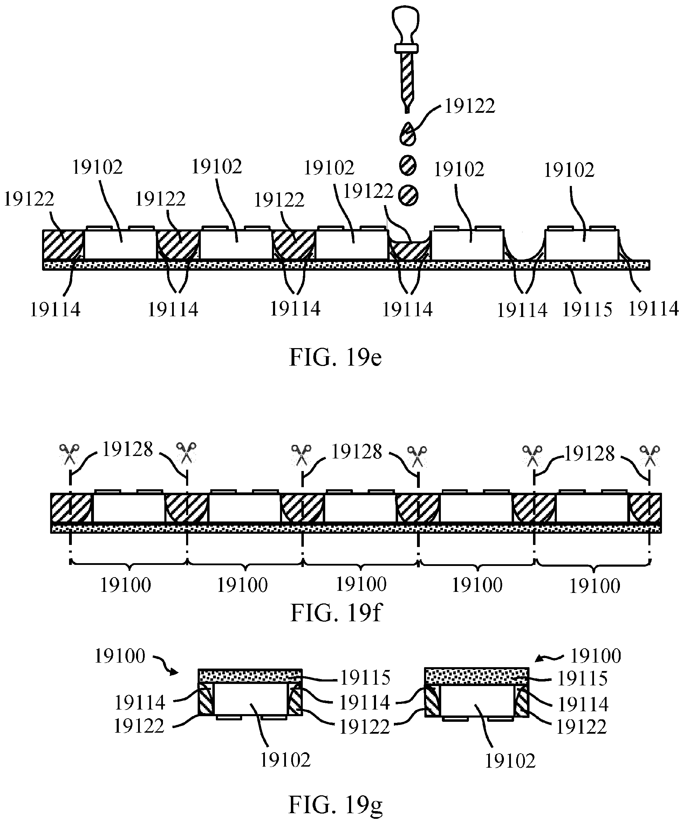

As indicated in **FIGS. 19d and 19e,** there is a square lattice of valleys **19126** between rows and columns of LED chips **19102.** The valleys **19126** are filled with a light reflective material **19122** such as, for example, a white silicone material (**FIG. 19e**).

Finally, as shown in **FIG. 19f,** individual CSP devices **19100** are produced by cutting along cut lines **19128.** The cut individual CSP devices **19100** can be seen in **FIG. 19g.**

It will be appreciated that a similar method can be used to manufacture the device **18100** of **FIG. 18** using a photoluminescence wavelength conversion component **18112** comprising a double-layer photoluminescence film **18115** comprising first and second photoluminescence layers.

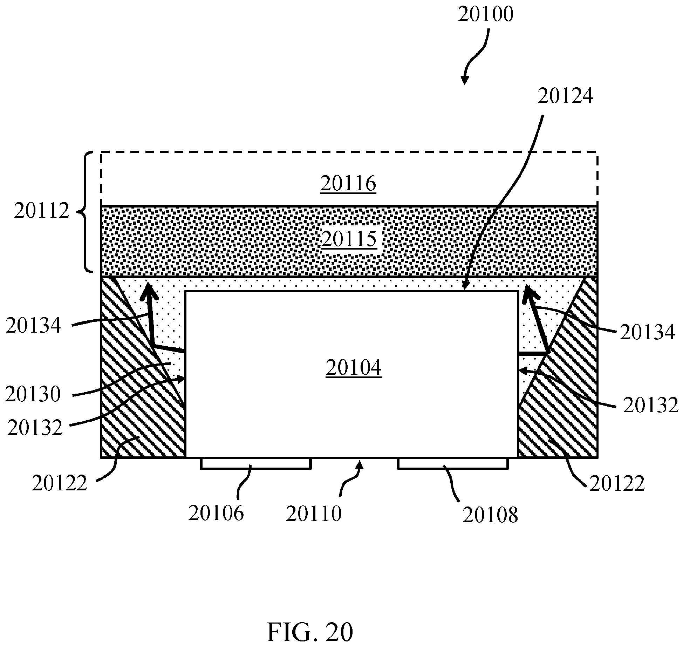

**FIG. 20** is a schematic representation of a sectional side view of CSP full spectrum white light emitting device **20100** according to an embodiment of the invention. The device **20100** of **FIG. 18** is similar to that of **FIG. 17a,** except that the light transmissive (material) region **20130** disposed between the four side faces **20132** of the LED chip **20104** and the light reflective material **20122** has a different configuration. In this embodiment, the light transmissive (material) region **20130** still reduces in thickness in a direction from the top face **20124** of the LED chip **20104** to the bottom face **20110** of the LED chip **20104,** but the light transmissive (material) region **20130** reduces in thickness substantially linearly. Accordingly, the shape/surface of the light reflective material **20122** is angled such that it is congruent with the surface of the linearly reducing thickness light transmissive (material) region **20130**. In this way, light **20134** being emitted by the side faces **20132** of the LED chip **20104** is redirected towards the photoluminescence layer **19115** to improve the light conversion efficiency of the device **20100.**

In summary, it will be appreciated that light emitting devices in accordance with the invention comprising a broadband solid-state excitation source enable the implementation of full spectrum white light emitting devices that are characterized by generating white light having a color temperature in a range 1800K to 6800K with one or more of (i) over a wavelength range from about 430 nm to about 520 nm, the maximum percentage intensity deviation of light emitted by the device is less than 60% from the intensity of light of a black-body curve or CIE Standard Illuminant D of the same Correlated Color Temperature, (ii) a spectrum having a CAF that is within 5%, 4%, 2%, or 1% of the black-body curve/CIE Standard Illuminant D; (iii) a CRI R9 and/or a CRI R8 that less than 90, (iv) a spectrum whose intensity decreases from its maximum value in the orange to red region of the spectrum to about 50% of said maximum value at a wavelength in a range from about 645 nm to about 695 nm, (v) a spectrum whose intensity decreases from its maximum value in the orange to red region of the spectrum to about 50% of said maximum value at a wavelength in a range from about 645 nm to about 695 nm and has a CRI Ra greater than or equal to 85, CRI R1 to CRI R7 and CRI R10 to CRI R15 greater than or equal to 90, CRI R8 less than 72, and CRI R9 greater than 10 and less than 90, (vi) a spectrum whose intensity decreases from its maximum value in the orange to red region of the spectrum to about 50% of said maximum value at a wavelength in a range from about 645 nm to about 695 nm and has a CRI Ra greater than or equal to 95, CRI R1 to CRI R8 and CRI R10 to CRI R15 greater than or equal to 90, and CRI R9 greater than 50 and less than 90, and (vii) a spectrum whose intensity decreases from its maximum value in the orange to red region of the spectrum to about 50% of said maximum value at a wavelength in a range from about 645 nm to about 695 nm and has a CRI Ra greater than or equal to 95, and CRI R1 to CRI R15 greater than or equal to 90.

Full spectrum white light emitting devices according to various embodiments of the invention can be implemented as CSP (Chip Scale Packaged) lighting devices. CSP full spectrum white light emitting devices find particular utility as a camera flash for cell phones and other compact devices, such as tablets. In the case of a camera flash, the device preferably generates white light with a color temperature of 5000K to 6500K. It will be understood that the examples/test data provided herein while relating to packaged light emitting devices are equally applicable to CSP light emitting devices including a camera flash.

Although the present invention has been particularly described with reference to certain embodiments thereof, it should be readily apparent to those of ordinary skill in the art that changes and modifications in the form and details may be made without departing from the spirit and scope of the invention.

List of Reference Numerals - FIGS. 1-9 (# = Figure number)

| | |
|---|---|
| #10 | White light emitting device |
| #12 | Body |
| #14 | Base |
| #16 | Wall portion |
| #18 | Top |
| #20 | Broadband blue excitation source |
| #22 | Substrate (Metal core printed circuit board) |
| #24 | Reflective surface |
| #26 | Reflective surface |
| #28 | Photoluminescence wavelength conversion component |
| #30 | First solid-state light source |
| #32 | Second solid-state light source |
| #34 | Substrate |
| #36 | Electrical contact |
| #38 | Electrical conduct |
| #40 | Optical encapsulant |
| #41 | Solid-State light source |
| #42 | Broadband blue excitation light |
| #44 | Package |
| #46 | Package upper portion |
| #48 | Package base portion |
| #50 | Recess |

| #52 & #54 | Electrical connectors |
| #56 to #60 | Electrode contact pads |
| #62 | Thermally conductive pad |
| #64 | Bond wire |
| #66 | Photoluminescence material loaded optical encapsulant |
| #68 | MCPCB (Metal Core Printed Circuit Board) |
| #70 | wall |
| #72 & #74 | Electrical contacts |
| #80 | Emission peak - Excitation source |
| #82 & #84 | Emission peaks - Excitation source |
| #86 | Trough |
| #88 | Trough |
| #90 | Intensity of spectrum at $\lambda_{maxdev}$ |
| #92 | Intensity of bbc (black body curve) at $\lambda_{maxdev}$ |

List of Reference Numerals FIGS. 10 - 14 (# = Figure number)

| #100 | CSP (Chip Scale Packaged) White Light emitting device |
| #102 | LED flip chip |
| #104 | LED die (chip) |
| #106 | Anode contact pad |
| #108 | Cathode contact pad |
| #110 | LED flip chip base |
| #112 | Photoluminescence wavelength conversion component |
| #114 | Light transmissive bonding layer/material |
| #115 | Photoluminescence layer |
| #116 | Light transmissive layer/substrate |
| #118 | First photoluminescence layer |
| #120 | Second photoluminescence layer |
| #122 | Light reflective material layer |
| #124 | LED chip light emitting face |
| #126 | Valleys |
| #128 | Cut lines |
| #130 | Light transmissive region (layer)/material |
| #132 | Light emitting side face of LED chip |
| #134 | Light emitted from side face(s) of LED chip |

**Claims**

1. A white light emitting device comprising:

a chip scale packaged broadband LED flip chip for generating broadband light of dominant wavelength from about 420 nm to about 480 nm and a FWHM from 25 nm to 50 nm; and
at least one photoluminescence layer covering a light emitting face of the broadband LED flip chip;
wherein the broadband LED flip chip comprises a broadband InGaN/GaN LED chip having an active region for directly generating blue light emissions of at least three different wavelengths using different quantum wells in a multiple-quantum well (MQW) structure, and
wherein the at least one photoluminescence material layer comprises a first photoluminescence material for generating light with a peak emission wavelength from 490 nm to 550 nm; and a second photoluminescence material for generating light with a peak emission wavelength from 600 nm to 680 nm.

2. The device of Claim 1, wherein the device comprises a camera flash, and wherein the device is for generating white light with a color temperature from 5000K to 6500K.

3. The device of Claim 1 or Claim 2, wherein the broadband LED flip chip has a bottom face comprising anode and cathode contact pads and a light emitting top face, and wherein the at least one photoluminescence layer covers at least the light emitting top face.

4. The device of Claim 3, comprising a light transmissive material layer between the at least one photoluminescence layer and the light emitting top face of the LED flip chip.

5. The device of Claim 3, wherein the at least one photoluminescence layer is in direct contact with the light emitting top face of the LED flip chip.

6. The device of any of Claims 1 to 5, wherein the LED flip chip comprises light emitting side faces.

7. The device of Claim 6, wherein the at least one photoluminescence layer covers the light emitting side faces of the LED flip chip.

8. The device of Claim 6 or Claim 7, comprising a light reflective material covering the light emitting side faces of the LED flip chip.

9. The device of Claim 8, comprising a light transmissive material disposed between the light reflective material and the light emitting side faces of the LED flip chip, and wherein the light transmissive material is enclosed by the light reflective material and the at least one photoluminescence layer.

10. The device of Claim 9, wherein the light transmissive material reduces in thickness in a direction from the top face of the LED flip chip to the bottom face of the LED flip chip.

11. The device of Claim 9 or Claim 10, wherein the light transmissive material is arcuate in form, or wherein the light transmissive material reduces in thickness substantially linearly.

12. The device of any of Claims 9 to 11, wherein the light reflective material is in direct contact with the light transmissive material, or wherein the light transmissive material comprises a layer between the at least one photoluminescence layer and the light emitting top face of the LED flip chip.

13. The device of Claim 9, wherein the light transmissive material is in direct contact with at least one of:

- the light reflective material;
- the light emitting top face of the LED flip chip;
- the light emitting side faces of the LED flip chip; or
- the at least one photoluminescence layer.

14. The device of any of Claims 1 to 13, wherein an intensity of the white light decreases from its maximum value in the orange to red region of the spectrum to about 50% of said maximum value at a wavelength from about 645 nm to about 695 nm.

15. The device of any of Claims 1 to 14, wherein the device for generating white light having a Correlated Color Temperature and an intensity versus wavelength spectrum, which over a wavelength range 460 nm to 600 nm, a maximum percentage deviation between the normalized intensity of the full spectrum white light emitted by the device compared with the normalized intensity of light of a black-body spectrum or CIE Standard Illuminant D of the same Correlated Color Temperature is less than $\pm 30\%$, optionally wherein the maximum percentage deviation is less than $\pm 20\%$ or is less than $\pm 10\%$.

FIG. 1a

SECTION A-A

FIG. 1b

242

FIG. 2a

FIG. 2b

FIG. 3a

FIG. 3b

FIG. 4a

SECTION A-A

FIG. 4b

FIG. 5

EP 4 411 842 A1

FIG. 6

FIG. 7a

FIG. 7b

FIG. 7c

FIG. 8

FIG. 9a

FIG. 9b

10100

10124

10116

10112

10115

10114

10104

10102

10106    10110    10108

FIG. 10a

10112

10100

FIG. 10b

10106    10110    10108

10100

FIG. 10c

10124

10116

10112    10115

10114

10104

10102

10108

FIG. 10d

FIG. 11

12100

12124

12115

12112

12104

12102

12132

12132

12106          12110          12108

SECTION A-A

FIG. 12a

B

12112

A                    A

12115

B

12110

FIG. 12b

12106    12132    12110    12108

12132

12112

12132

12100

12132

**FIG. 12c**

12124

12115

12100

12112

12102

12104

12132

12132

12108

SECTION B-B

**FIG. 12d**

FIG. 13

14100

14124

14116

14112

14115

14114

14122

14122

14132

14104

14132

14102

14106    14110    14108

SECTION A-A

FIG. 14a

B

14112

A                    A

14115

14100

B

FIG. 14b

FIG. 14c

SECTION B-B

FIG. 14d

FIG. 15

FIG. 16a

FIG. 16b

FIG. 16c

FIG. 16d

16122    16102    16122    16102    16122    16102    16122    16102    16126    16102    16126

FIG. 16e

16128    16128    16128

16100    16100    16100    16100    16100

FIG. 16f

16100    16100

16112    16112

16122    412    16122    16122    412    16122

FIG. 16g

SECTION A-A

FIG. 17a

FIG. 17b

17106   17132 17110   17108

17132

17122

17132

17100

17132

**FIG. 17c**

17124   17116

17112   17115

17130

17134

17132   17104   17130

17122   17122

17110   17108

**SECTION B-B**

**FIG. 17d**

FIG. 18

FIG. 19a

FIG. 19b

FIG. 19c

FIG. 19d

19122

19102          19102          19102          19102          19102

19122      19122      19122      19122

19114      19114      19114      19114      19114  19115  19114

FIG. 19e

19128          19128          19128

19100          19100          19100          19100          19100

FIG. 19f

19100                                          19100

19115                          19115
19114                          19114
19122                          19122
19102                          19102

FIG. 19g

FIG. 20

Europäisches
Patentamt

European
Patent Office

Office européen
des brevets

# EUROPEAN SEARCH REPORT

**Application Number**

EP 24 15 5881

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/131618 A1 (YUAN XIANGLONG [US] ET AL) 6 May 2021 (2021-05-06) | 1-3,5-7, 14,15 | INV. H01L33/06 H01L33/50 |
| Y | * paragraphs [0016], [0119]; claims 7,29,38,39; figures 2b,4b,14 * | 4,6,8-13 | |
| | ----- | | ADD. |
| X | US 2017/084587 A1 (HUNG CHENG-WEI [TW] ET AL) 23 March 2017 (2017-03-23) * claims 2,12,15,17; figures 2b,4b * | 1-3,5-7, 14,15 | H01L33/60 |
| | ----- | | |
| Y | WO 2021/007123 A1 (INTEMATIX CORP [US]) 14 January 2021 (2021-01-14) * paragraph [0028]; figure 1 * | 4,6,8-13 | |
| | ----- | | |

**TECHNICAL FIELDS
SEARCHED      (IPC)**

H01L

The present search report has been drawn up for all claims

| Place of search | Date of completion of the search | Examiner |
|---|---|---|
| The Hague | 18 June 2024 | Pérennès, Frédéric |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.........................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 15 5881

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2024

| Patent document cited in search report | | Publication date | Patent family member(s) | | Publication date |
|---|---|---|---|---|---|
| US 2021131618 | A1 | 06-05-2021 | CN | 112470296 A | 09-03-2021 |
| | | | EP | 3811421 A1 | 28-04-2021 |
| | | | JP | 2021536118 A | 23-12-2021 |
| | | | JP | 2023058559 A | 25-04-2023 |
| | | | TW | 202006970 A | 01-02-2020 |
| | | | US | 10371325 B1 | 06-08-2019 |
| | | | US | 2020347999 A1 | 05-11-2020 |
| | | | US | 2021131618 A1 | 06-05-2021 |
| | | | US | 2023288033 A1 | 14-09-2023 |
| | | | WO | 2020003008 A1 | 02-01-2020 |
| US 2017084587 | A1 | 23-03-2017 | CN | 106549092 A | 29-03-2017 |
| | | | CN | 111211206 A | 29-05-2020 |
| | | | CN | 111223975 A | 02-06-2020 |
| | | | US | 2017084587 A1 | 23-03-2017 |
| | | | US | 2018211942 A1 | 26-07-2018 |
| | | | US | 2020105725 A1 | 02-04-2020 |
| WO 2021007123 | A1 | 14-01-2021 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10644223
- US 8679367 B
- US 8597545 B
- US 8663502 B
- US 20170145309 A
- US 7655156 B

**Non-patent literature cited in the description**

- **TRAN C A et al.** Growth of InGaN multiple-quantum-well blue light-emitting diodes on silicone by metal organic vapor phase epitaxy. *Appl. Phys. lett.,* 1999, vol. 75, 1494